# EUROPEAN PATENT APPLICATION

(11) **EP 2 221 859 A1**
(43) Date of publication of application: **25.08.2010**
(21) Application number: 08849670.8
(22) Date of filing: 11.11.2008
(51) Int. Cl.: H01L 21/336, H01L 21/20, H01L 21/28, H01L 29/161, H01L 29/423, H01L 29/47, H01L 29/49, H01L 29/78, H01L 29/872, H01L 29/94

(54) **SEMICONDUCTOR DEVICE AND SEMICONDUCTOR DEVICE MANUFACTURING METHOD**

(30) Priority: 12.11.2007 JP 2007293258
(71) Applicant: Hoya Corporation, Tokyo 161-8525 (JP); Kobayashi, Hikaru, Kyoto 605-0981 (JP)
(72) Inventor: KOBAYASHI, Hikaru, Kyoto-shi Kyoto 605-0981 (JP); NAGASAWA, Hiroyuki, Tokyo 161-8525 (JP); HATTA, Naoki, Tokyo 161-8525 (JP); KAWAHARA, Takamitsu, Tokyo 161-8525 (JP)
(74) Representative: Zimmermann & Partner
(86) International application number: PCT/JP2008/070458
(87) International publication number: WO 2009/063844

(57) **Abstract**

A semiconductor device comprises a semiconductor substrate made of silicon carbide, a gate insulating film formed on the semiconductor substrate, and a gate electrode formed on the gate insulating film. The junction surface of the semiconductor surface joined with the gate insulating film is macroscopically parallel to a nonpolar face and microscopically comprised of the nonpolar face and a polar face. In the polar face, either a Si face or a C face is dominant. A semiconductor device comprises a semiconductor substrate comprised of silicon carbide and a gate electrode formed on the semiconductor substrate. The junction surface of the semiconductor surface joined with the electrode is macroscopically parallel to a nonpolar face and microscopically comprised of the nonpolar face and a polar face. In the polar face, either a Si face or a C face is dominant. The present invention is a semiconductor device having a silicon carbide substrate, and the electrical characteristics and the stability of the interface between the electrode and the silicon carbide or between the oxide film (insulating film) and the silicon carbide in the nonpolar face of a silicon carbide epitaxial layer can be improved.

## Description

### Cross-reference to related patent applications

The present application claims priority under Japanese Patent Application 2007-293258, filed on November 12, 2007, the entire contents of which are hereby incorporated by reference.

### Technical field

The present invention relates to a semiconductor device employing silicon carbide, which regarded as a promising material for high-performance semiconductor devices, and to a method for manufacturing the same. More specifically, the present invention relates to a semiconductor device that is suited to electric power applications and achieves a good breakdown voltage, rectifying properties, or low loss properties in a metal/insulating film/semiconductor structure or a metal/semiconductor structure, and to a method for manufacturing the same.

### Background art

Conventionally, power semiconductor devices have been fabricated with a silicon substrate having a 1.1 eV forbidden band gap. By replacing the substrate to silicon carbide, with a forbidden band gap between 2.2 to 3.2 eV, as the substrate, it is possible to achieve low power consumption and high breakdown voltage simultaneously. Additionally, the intrinsic carrier concentration of silicon carbide is ten orders of magnitude lower than that of silicon, permitting the operation of semiconductor devices such as transistors and diodes without loss of efficiency at higher temperatures.

Power semiconductor devices utilizing the superiority of silicon carbide are fabricated in the form of Schottky diodes employing a metal/semiconductor structure, or field-effect transistors (FETs) and the like employing a metal/gate insulation film/semiconductor structure (MOS structure) or metal/semiconductor structure (MES structure). These semiconductor devices are all unipolar operations, and thus have extremely short accumulating time of carriers and can switch rapidly.

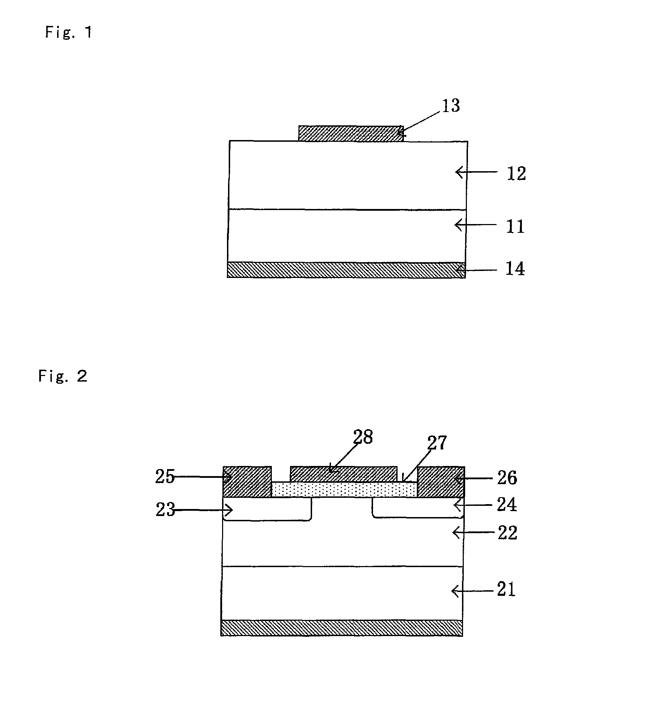

Fig. 1 shows the basic structure of a Schottky barrier diode fabricated on silicon carbide. An electrode ("Schottky electrode" hereinafter) 13 comprised of Schottky metal is deposited on the surface of an epitaxial layer 12 of silicon carbide formed on a silicon carbide substrate 11. Rectifying properties are realized by the Schottky barrier generated at the interface of silicon carbide epitaxial layer 12 and the Schottky metal. For example, when an impurity introduced into the silicon carbide acts as a donor, the Schottky barrier inhibits electrons from diffusing from Schottky electrode 13 into silicon carbide epitaxial layer 12, realizing rectifying properties. That is, a conducting state is created when a forward bias is applied to the Schottky electrode 13 side and a reverse bias is applied to the silicon carbide epitaxial layer 12 side, and an blocking state is created when a reverse bias is applied to the Schottky electrode 13 side and a forward bias is applied to the silicon carbide epitaxial layer 12 side.

Electrode 14 in the lower portion of the substrate differs from Schottky electrode 13 in that it does not exhibit rectifying properties and reduces a voltage drop when the device is operated as a conducting state. It thus desirably has as low a resistance as possible. In a Schottky barrier diode thus configured, the thickness of silicon carbide epitaxial layer 12, the concentration of impurity that are added to it, and the type of Schottky electrode are determined to achieve desired values in terms of the height of the Schottky barrier and diode characteristics such as the breakdown voltage and the specific on-resistance.

Generally, the height of the Schottky barrier at the interface of the semiconductor/Schottky electrode is expressed as the sum of the difference in static potential (internal work function) between the Schottky electrode and the semiconductor and the electric potential present at the interface. In silicon carbide, which is a wide gap semiconductor with considerable ionic properties, the effect of the electric dipole present at the interface is greater and the height of the Schottky barrier depends strongly on the surface state of the silicon carbide.
Thus, to form a silicon carbide Schottky barrier diode with stable characteristics, it is desirable to employ a surface that is as smooth as possible and has as low a crystal defect density as possible on a face of specific polarity (such as face (0001) Si face or the (000-1) C of hexagonal silicon carbide).

However, numerous micropipe defects, screw dislocation defects, and the like are present within the polar face of hexagonal silicon carbide. These defects are distributed in the epitaxial layer while propagating in the same manner in which they are present in the substrate, and are known to greatly degrade device performance. To prevent the propagation of these micropipe defects, for example, in Japanese Unexamined Patent Publication (KOKAI) No. 2000-44396 (Patent Document 1), a technique is reported that promotes the closing of micropipe defects by employing a substrate that is imparted with an missoriented angle of 3 to 8 degrees from the (0001) face and by matching the direction in which the silicon carbide source gas is supplied to the direction of growth of the step flow. However, this technique does not completely prevent the propagation of micropipe defects. Since an epitaxial layer is grown on a substrate having an missoriented angle, there are problems in that the bunching provability of steps on the crystal surface increases, basal plane dislocation tends to be exposed on the surface, flatness of the epitaxial layer surface becomes worse, the density of other defects increases, and the like.

As one method of solving these problems, Japanese Unexamined Patent Publication (KOKAI) No. 2003-119097 (Patent Document 2) proposes a technique of multiple repeating cycles of growth in the a-axis direction followed by growth in the c-axis direction to theoretically reduce the defect density in the polar face of the substrate to zero. However, this technique involves extremely complex steps and presents the problem of making it difficult to reduce manufacturing costs.

Additionally, Japanese Unexamined Patent Publication (KOKAI) No. 2000-319099 (Patent Document 3) describes depositing a buffer layer for irregular lattices on the hexagonal silicon carbide (11-20) face, to which micropipe defects in the substrate do not propagate, followed by epitaxial growth to prevent the propagation of micropipe defects and to permit the formation of a silicon carbide epitaxial layer with a smooth crystal surface.

The structure and characteristics of a MOS field-effect transistor (MOSFET) will be described next using Fig. 2. Fig. 2 is a common lateral MOSFET fabricated on silicon carbide. In this MOSFET, a silicon carbide epitaxial layer 22 is grown on a silicon carbide substrate 21. A prescribed dopant is added at a prescribed concentration to the silicon carbide epitaxial layer. The introduced dopant in this process is generally a p-type dopant like aluminum, boron, and so on. The concentration thereof is selected between 1 x 10¹⁴ to 5 x 10¹⁶/cm³ determined by desired breakdown voltage of the device. Doped regions referred to as a source region 23 and a drain region 24 are contained in silicon carbide epitaxial layer 22. Both the source region and drain region are doped with dopants exhibiting an opposite conducting type from that of the dopant added to the silicon carbide epitaxial layer. For a p-type silicon carbide epitaxial layer, n-type nitrogen is introduced. The doping concentration is adequately high relative to that of the silicon carbide epitaxial layer, exceeding 1 x 10¹⁸/cm³. As a result, two disconnected p-n junctions are formed in the silicon carbide epitaxial layer. Source electrode 25 and drain electrode 26 are formed so as to act as an ohmic contact at source region 23 and drain region 24, respectively.

In a lateral MOSFET, to decrease the voltage drop as low as possible when the device turns on, both the source electrode and drain electrode are formed so as to have the lowest ohmic resistance possible. A thin oxide film is formed as a gate insulating layer 27 on the surface on the region separating source region 23 and drain region 24. The oxide film can be formed by the thermal oxidation method, nitric acid oxidation method, chemical vapor deposition (CVD) method, or the like. The thickness of the oxide film is precisely adjusted according to the device design.

A gate electrode 28 is deposited on gate insulating layer 27. In this MOSFET, source region 23 and drain region 24 are separated by reveres connection of two p-n junctions, and do not conduct current. However, when a positive bias of a certain level relative to the source electrode (threshold voltage) is applied to the gate electrode, an inversion layer is generated at just forms in a portion of the silicon carbide epitaxial layer immediately beneath the interface with the gate insulating layer, forming an n-type region (channel) electrically connecting n-type source region 23 with drain region 24, which is also n-type. Here, when a positive voltage relative to the source is applied to the drain electrode, electrons drift from the source region to the drain region and a current flows from the drain electrode to the source electrode. In this process, the resistance of the MOSFET is proportional to the product of the total number of electrons traveling through the channel region multiplied by their velocity. Further, the velocity of the electrons traveling through the channel region is proportional to the electric field applied between the source-drain and the mobility in the channel region (channel mobility). That is, the greater the positive bias applied to the gate, or the higher the degree of mobility, the specific on-resistance of the MOSFET can be reduced lowering the power loss.

Channel mobility is affected by the smoothness of the gate insulating film/silicon carbide interface and the density of defects (interface state density) contained in the silicon carbide in the vicinity of the gate insulating film interface. The smoother the interface of the gate insulating film/silicon carbide, the lower the interface state density resulting in enhancement of mobility.

To maintain a smooth gate insulating film/silicon carbide interface, it is possible to form the gate insulating film by CVD instead of by thermal oxidation. For example, using a low-pressure vapor phase epitaxal system with reactive gases like SiH₄ and N₂O under conditions of a temperature of 750-850°C and a pressure of 0.5 Torr, it is possible to form an SiO₂ film on an SiC substrate. Using the plasma CVD method, it is possible to form an SiO₂ film at an even lower temperature than by the LPCVD method. However, a SiO₂ film formed by the CVD method is of lower density than that formed by thermal oxidation, contains more impurities than a thermal oxidation film, and degrades dielectric breakdown electric field and long term reliability.

When forming an SiO₂ film by the CVD method, the silicon carbide surface is exposed to a high-temperature oxidizing atmosphere during SiO₂ film formation, and interface states, which act as charge trapping centers, are generated at the interface. Thus, during SiO₂ film formation, it is necessary to prevent the formation of interface states and reduce the density of interface states as much as possible. To solve this problem, the silicon carbide substrate is nitrided before forming the SiO₂ film, and the main surface of the silicon carbide is deactivated to obtain a high quality MOS interface. As described in Japanese Unexamined Patent Publication (KOKAI) No. 2006-156478 (Patent Document 4), the CVD oxide film can be nitrided (POA with N₂O gas or the like) to improve the quality of the gate insulating film and achieve high channel mobility. Such nitriding treatment enhances channel mobility at the gate insulating film/silicon carbide interface. However, the introduced nitrogen remains at just the oxide film/silicon carbide interface, generating a positive fixed charge. This fixed charge causes the flat band voltage to shift in the negative direction, rendering the gate threshold voltage of the MOSFET unstable. Simultaneously, it compromises the durability of the gate insulating film to charge accumulation, and may cause the device to lose long-term stability.

In MOS-type and MES-type field-effect transistors, defects contained in the channel region affect channel mobility, leakage current, and the like. Accordingly, various inventions have been devised to reduce the defect density in the channel region. For example, in hexagonal silicon carbide, epitaxial growth has been intentionally conducted on the (0001) face, which is slightly inclined towerd the <11-20> direction, to reduce the defect density on the (0001) face. However, there are problems with this method in that an atomic step bunching phenomenon tends to occur on the crystal surface increasing the surface roughness of the homoepitaxial layer. This results in reduction of channel mobility. To solve these problems, as described in Japanese Unexamined Patent Publication (KOKAI) No. 2006-66722 (Patent Document 5), a method has been proposed of slightly tilting the (0001) face of the hexagonal silicon carbide substrate by 0.5 to 10° in the <21-30> direction and forming a buffer layer on that surface to alleviate the distortion due to lattice mismatching caused by differences in dopant densities. This method makes it possible to obtain a smooth silicon carbide surface and oxide film interface.

Additional methods of enhancing the channel mobility of field-effect transistors have been proposed in the form of processing methods to prevent the adhesion of contaminant elements through hydrogen termination while simultaneously rendering the silicon carbide surface in which the channel is formed as close as possible to a completely smooth and clean crystal surface. For example, Japanese Unexamined Patent Publication (KOKAI) No. 2006-351744 (Patent Document 6) discloses the flattening and cleaning of the surface by feeding hydrogen in a reduced pressure reaction furnace at 1,500°C or higher to etch the surface by from several nm to about 0.1 micrometer prior to the step of forming a gate insulating film on the silicon carbide substrate.
(Patent Document 1) Japanese Unexamined Patent Publication (KOKAI) No. 2000-44396
(Patent Document 2) Japanese Unexamined Patent Publication (KOKAI) No. 2003-119097
(Patent Document 3) Japanese Unexamined Patent Publication (KOKAI) No. 2000-319099
(Patent Document 4) Japanese Unexamined Patent Publication (KOKAI) No. 2006-156478 or WO 0068474 A1
(Patent Document 5) Japanese Unexamined Patent Publication (KOKAI) No. 2006-66722
(Patent Document 6) Japanese Unexamined Patent Publication (KOKAI) No. 2006-351744 or its English family, US2007015333 A1 Patent Documents 1-6 are is expressly incorporated herein by reference in their entirety.

The present invention, devised in light of the above-described problems, has for its object to provide a means of enhancing the stability and electrical characteristics of the electrode/silicon carbide interface, or oxide film (insulating film)/silicon carbide interface, on a nonpolar face of the silicon carbide epitaxial layer, regardless of the defect density of the substrate, in a semiconductor device employing a silicon carbide substrate, such as a Schottky barrier diode or MOSFET.

The present invention provides means of achieving uniform, stable rectifying characteristics over a large area, without the complexity of element manufacturing steps in a Schottky barrier diode, and of inhibiting Coulomb scattering and enhancing channel mobility while improving the flatness of the gate insulating film/silicon carbide interface in a MOSFET. Further, the present invention requires neither the introduction of nitrogen into a CVD film nor an N₂O treatment following the formation of the gate insulating film, thereby simplifying the element manufacturing steps, eliminating the localized presence of nitrogen at the gate insulating film/silicon carbide interface, and eliminating a cause of the degradation factor of electric characteristic control and long-term stability.

### Disclosure of the Invention

The means of solving the problem based on the present invention are as follows:
[1] A semiconductor device, comprising a semiconductor substrate comprised of silicon carbide, a gate insulating film formed on the semiconductor substrate, and a gate electrode formed on the gate insulating film, characterized in that:
   the junction surface of the semiconductor surface and the gate insulating film is macroscopically parallel to a nonpolar face, is microscopically comprised of the nonpolar face and a polar face, with either an Si face or a C face being dominant in the polar face.
[2] A semiconductor device, comprising a semiconductor substrate comprised of silicon carbide, a gate insulating film formed on the semiconductor substrate, and a gate electrode formed on the gate insulating film, characterized in that:
   the junction surface of the semiconductor surface and the gate insulating film comprises a terrace face, and a step edge oriented in a specific direction,
   the terrace face corresponds to a nonpolar face, and the step edge is comprised of a polar face of either an Si face or a C face.
[3] A semiconductor device, comprising a semiconductor substrate comprised of silicon carbide, a gate insulating film formed on the semiconductor substrate, and a gate electrode formed on the gate insulating film, characterized in that:
   the junction surface of the semiconductor surface and the gate insulating film comprises a terrace face, and a step edge oriented in a specific direction,
   the terrace face corresponds to a nonpolar face, and
   the terrace face has a ratio of the width in the direction of orientation of the step edge to the width in the in-plane direction orthogonal to the direction of orientation of the step edge of ten-fold or greater.
[4] A semiconductor device, comprising a semiconductor substrate comprised of silicon carbide, a gate insulating film formed on the semiconductor substrate, and a gate electrode formed on the gate insulating film, characterized in that:
   the junction surface of the semiconductor surface and the gate insulating film is macroscopically parallel to a nonpolar face, comprises a step edge oriented in a specific direction, and the height of the step edge falls within a range of 0.5 to 10 nm.
[5] A semiconductor device, comprising a semiconductor substrate comprised of silicon carbide and an electrode formed on the semiconductor substrate, characterized in that:
   the junction surface of the semiconductor substrate surface and the electrode is macroscopically parallel to a nonpolar face and is microscopically comprised of the nonpolar face and a polar face, with either an Si face or a C face being dominant in the polar face.
[6] A semiconductor device, comprising a semiconductor substrate comprised of silicon carbide and an electrode formed on the semiconductor substrate, characterized in that:
   the junction surface of the semiconductor substrate surface and the electrode comprises a terrace face, and a step edge oriented in a specific direction;
   the terrace face corresponds to a nonpolar face; and
   the step edge face is comprised of a nonpolar face and a polar face in the form of either an Si face or a C face.
[7] A semiconductor device, comprising a semiconductor substrate comprised of silicon carbide and an electrode formed on the semiconductor substrate, characterized in that:
   the junction surface of the semiconductor substrate surface and the electrode comprises a terrace face, and a step edge oriented in a specific direction,
   the terrace face corresponds to a nonpolar face, and
   terrace face has a ratio of the width in the in-plane direction orthogonal to the step direction to the width in the step direction of ten-fold or greater.
[8] A semiconductor device, comprising a semiconductor substrate comprised of silicon carbide and an electrode formed on the semiconductor substrate, characterized in that:
   the junction surface of the semiconductor substrate surface and the electrode is macroscopically parallel to a nonpolar face and contains recessions and protrusions oriented in a specific direction; and
   the height between the recessions and protrusions falls within a range of 0.5 to 10 nm.
[9] The semiconductor device according to any one of [1], [2], [5], and [6], characterized in that the proportion of the area occupied by one of the polar faces in the junction surface falls within a range of 0.75 to 1 when the area of all of the polar faces in the junction surface is denoted as 1.
[10] The semiconductor device according to any one of [2], [3], [6], and [7], characterized in that the width of the terrace face (the width in the substrate in-plane direction orthogonal to the direction of orientation of the step edge) is 0 to 100 nm.
[11] The semiconductor device according to any one of [1] to [10], characterized in that the semiconductor substrate comprises a silicon carbide epitaxial film formed on a single-crystal semiconductor substrate.
[12] The semiconductor device of any one of [1] to [11], characterized in that the semiconductor substrate is cubic silicon carbide and the nonpolar face is the {001} or {110} planes.
[13] The semiconductor device according to any one of [1] to [11], characterized in that the semiconductor substrate is hexagonal silicon carbide and the nonpolar plane corresponds to any one of the {11-20}, {1-100}, and {03-38} planes.
[14] The semiconductor substrate of any one of [1], [2], [5], [6], and [9], characterized in that the specified polar face is the Si polar face.
[15] A method for manufacturing the semiconductor device according to any one of [1] to [14], characterized by comprising the steps of:
   preparing a silicon carbide semiconductor substrate having at least one dominant surface that is a nonpolar face;
   forming steps oriented in a specific direction on at least a portion of a nonpolar face of the semiconductor substrate; and
   unifying the polarity of the step edge face to a specific polar face.
[16] The manufacturing method according to [15], characterized in that the step of forming steps in a specific direction and the step of unifying the polarity of the step edge face to a specific polar face are conducted before a step of forming a gate insulating film or electrode.

Conventionally, in a semiconductor device employing a silicon carbide substrate, the flatness of the substrate surface at the interface portion with the gate insulating film and the flatness of the substrate surface at the interface portion with the electrodes are known to affect the characteristics of the semiconductor device. Improvements have been made by betterment of the flatness of these interfaces.

The present inventors discovered that the polarity of the substrate surface at the interface portion with the gate insulating film and the polarity of the substrate surface at the interface portion with the electrodes are important factors affecting the characteristics of semiconductor devices. The present invention was devised on that basis.

For example, Patent Document 3 discloses that it is possible to prevent propagation of micropipe defects and grow a silicon carbide epitaxial layer having a smooth crystal surface by conducting epitaxial growth after depositing a buffer layer for lattice irregularities on the (11-20) face of hexagonal silicon carbide through which micropipe defects in the substrate do not propagate. However, since these face orientations are nonpolar faces, the polarity that is exposed on the outermost surface of the silicon carbide epitaxial layer is not uniformly established. As a result, there are problems in that control of electric dipole components is lost and the in-plane stability of Schottky barrier diode characteristics, such as the breakdown voltage, become worse.

Unifying the polar face of the silicon carbide surface is also extremely important for flattening the gate insulating film/silicon carbide interface in a MOSFET, for example. When forming a gate insulating film by thermal oxidation, for example, after growing a silicon carbide epitaxial layer 22 on a silicon carbide substrate 21, thermal oxidation is conducted in a dry or wet oxidations. However, the C face and Si face, which are polar faces of silicon carbide, exhibit different oxidation rates in the thermal oxidation process. In particular, the C (carbon) face oxidizes at about three times the rate of the Si (silicon) face. That is, on surfaces where different polar faces are simultaneously exposed, the different polar faces are thermally oxidized at different rates, resulting in thermal oxidation films of nonuniform in-plane film thickness. This nonuniformity in thermal oxidation film thickness compromises the flatness of the gate insulating film/silicon carbide interface. Thus, when thermal oxidation is conducted on silicon carbide in which the polar faces have not been unified to form a MOSFET, channel mobility is low and the original low loss property of silicon carbide is lost.

Nitriding a silicon carbide substrate prior to forming a SiO₂ film by CVD, deactivating the main surfaces of the silicon carbide to improve the quality of the MOS interface, and then nitriding the CVD oxide film (POA with N₂O or the like) improves the quality of the gate insulating film and achieves high channel mobility (for example, Patent Document 4). Such nitriding has the effect of increasing channel mobility at the gate insulating film/silicon carbide interface, but the nitrogen that is introduced at just the oxide film/silicon carbide interface, remaining as a positive fixed charge. This fixed charge causes the flat band voltage to shift in the negative direction, destabilizing the gate threshold voltage of the MOSFET. To inhibit variation in the gate threshold voltage, it is possible to intentionally add a fixed negative charge to the gate insulating film/silicon carbide interface. However, in the same manner as in a Schottky barrier diode, the polarity of the silicon carbide contacting the gate insulating film is not uniformly established. As a result, there are problems in that control of electric dipole components is loosen and channel mobility decreases due to Coulomb scattering.

One method of increasing channel mobility in a field-effect transistor is to conduct surface etching with hydrogen to flatten and clean the surface before the step of forming a gate insulating film on the silicon carbide substrate (for example, Patent Document 6). This method yields a smooth surface, but the fact that the polarity of the silicon carbide surface is not uniformly established for nonpolar faces is as set forth above. As a result, it is evident that control of electric dipole components is loosen and channel mobility decreases due to Coulomb scattering.

### Effect of the Invention

According to the present invention, even with silicon carbide having a nonpolar face as the dominant surface, a specific polar face is oriented at the microscopic interface with the gate insulating film or metal. Thus, no unwanted fields are produced between faces of differing polarity and no deterioration in the smoothness of the interface occurs due to differences in thermal oxidation rates or the like. As a result, in Schottky barrier diodes, uniform and stable rectifying properties are obtained over large areas without a complex device manufacturing process. In MOSFETs, Coulomb scattering is inhibited at the gate insulating film/silicon carbide interface and conduction losses are reduced due to enhanced channel mobility.

According to the present invention, since channel mobility is enhanced without adding nitrogen to the gate insulating film, the element manufacturing process is simplified and the effects of a fixed charge remaining at the interface are eliminated. As a result, device characteristics can be achieved as designed and the effect of good long-term stability is achieved.

### Best Modes of Carrying Out the Invention

The method of noting the direction and faces of crystals employed in the present specification will be described.

### [Direction]

A specific direction is denoted by [ ]. Equivalent directions are collectively denoted by < >. That is the <111> directions mean the set of [111], [-111], [1-11], [11-1], [-1-11], [1-1-1], [-11-1], and [-1-1-1].

### [Faces]

Similarly, a specific face is denoted by (). Equivalent faces are collectively denoted by {}.

Even where < > or { } are used as a collective denotation in the claims, a specific direction [ ] or a specific face ( ) may be employed in an embodiment, for example, in the specification. This is because the equivalent (010) face and (001) face cannot be simultaneously selected in the embodiments. When < > are employed in the claims, for example, in the statement that "the normal axis is approximately parallel to the <001> direction," it is equivalent in meaning to the statement, for example, that "the normal axis is approximately parallel to any one from among the [001] direction, [010] direction, or [100] direction."

### [Semiconductor devices]

The semiconductor device of the present invention means two types of semiconductor devices: semiconductor devices comprising a semiconductor substrate comprised of silicon carbide, a gate insulating film formed on the semiconductor substrate, and a gate electrode formed on the gate insulating film (referred to as "semiconductor device 1" hereinafter); and semiconductor devices comprising a semiconductor substrate comprised of silicon carbide, and an electrode formed on the semiconductor substrate (referred to as "semiconductor device 2" hereinafter). When reference is made simply to a "semiconductor device" below, the meaning is to be construed as including both semiconductor devices 1 and 2.

The semiconductor substrate employed in the semiconductor device of the present invention is comprised of single-crystal silicon carbide. The single-crystal silicon carbide can be cubic silicon carbide 3C-SiC or hexagonal SiC, for example. In this manner, the single-crystal silicon carbide is comprised principally of cubic and hexagonal silicon carbide. However, any single-crystal silicon carbide can be employed in the present invention. Since electron mobility is high in 3C-SiC crystals, and since cubic silicon carbide has a high figure of merit (FOM) as a semiconductor device material of high speed, low loss, and high frequency, cubic silicon carbide is desirably employed.

A semiconductor substrate comprised of single-crystal silicon carbide can be employed as is as a single-crystal semiconductor substrate, or a silicon carbide epitaxial film can be grown on the single-crystal semiconductor substrate. The impurity concentration of a semiconductor substrate used to form a semiconductor device is on the order of 10¹⁵/cm³, or an impurity concentration of a degree designed to precisely yield a p-n junction diode structure with an ion implantation zone is suitable. Accordingly, when the semiconductor substrate itself has such an impurity concentration to begin with, it can be employed as is as the single-crystal semiconductor substrate without providing a silicon carbide epitaxial film. When the single-crystal semiconductor substrate does not have such an impurity concentration, a silicon carbide homoepitaxial layer in which the impurity concentration has been adjusted is suitably provided.

The embodiments are described for fabrication of a vertical MOSFET. When employed in a vertical configuration, a drain electrode is provided on the back surface of the substrate. However, when an electrode is provided in an n-layer (EPI layer), it is difficult to obtain good ohmic contacts. Thus, an n- layer is formed over an n+ layer substrate. This limit does not apply when fabricating a lateral MOSFET.

Semiconductor device 1 is a transistor or a diode having a structure in which at least a portion of an electrode contacts the semiconductor through an insulating film beneath it. Semiconductor device 2 is a transistor or a diode in which the electrode contacts the semiconductor-without the presence of an insulating film. The transistor of semiconductor device 1 is, for example, a MOSFET, IGBT, or the like. The diode of semiconductor device 1 is, for example, a MOS diode or the like.
The diode of semiconductor device 2 is, for example, a p-n diode, Schottky diode, or the like (that is, other than a MOS diode). The transistor of semiconductor 2 is, for example, a MESFET, thyristor, GTO, or the like.

The material, shape, positioning, and the like of the gate insulating film and gate electrode in semiconductor device 1, as well as the material, shape, positioning, and the like of the electrode in semiconductor device 2, can be suitably selected based on the type of semiconductor device. The gate insulating film can be, for example, SiO₂, Al₂O₃, or the like. The gate electrode can be, for example, Al, poly-Si, or the like. The electrode in semiconductor device 2 can be, for example, Pt, Au, Ni, or the like.

Semiconductor device 1 will be described first below, followed by semiconductor device 2.

### [Semiconductor device 1]

Semiconductor device 1 is characterized in that the junction surface of the semiconductor substrate surface and the gate insulating film is macroscopically parallel to a nonpolar face, and is microscopically comprised of nonpolar faces and polar faces, with either a Si (silicon) face or C (carbon) face being dominant at the polar face (Form A).

Alternatively, semiconductor device 1 is characterized in that the junction surface of the semiconductor surface and the gate insulating film comprises a terrace face, and a step edge oriented in a specific direction, the terrace face corresponds to a nonpolar face, and the step edge is comprised of a polar face of either a Si face or a C face (Form B).

Alternatively, semiconductor 1 is characterized in that the junction surface of the semiconductor surface and the gate insulating film comprises a terrace face, and a step edge oriented in a specific direction, the terrace face corresponds to a nonpolar face, and the terrace face has a ratio of the width in the direction of orientation of the step edge to the width in the substrate in-plane direction that is orthogonal to the direction of orientation of the step edge of ten-fold or greater (Form C).

Alternatively, semiconductor 1 is characterized in that the junction surface of the semiconductor surface and the gate insulating film is macroscopically parallel to a nonpolar face, comprises a step edge oriented in a specific direction, and the height of the step edge falls within a range of 0.5 to 10 nm (Form D).

Semiconductor device 1 is characterized by the structure of the junction surface of the semiconductor substrate surface and the gate insulating film. The surface of the substrate comprised of single-crystal silicon carbide functioning as the junction surface with the gate insulating film is macroscopically parallel with a nonpolar face in Forms A and D. The surface of the substrate comprised of single-crystal silicon carbide serving as the junction surface with the gate insulating film comprises a terrace face and a step edge that is oriented in a specific direction, with the terrace face being a nonpolar face, in Forms B and C.

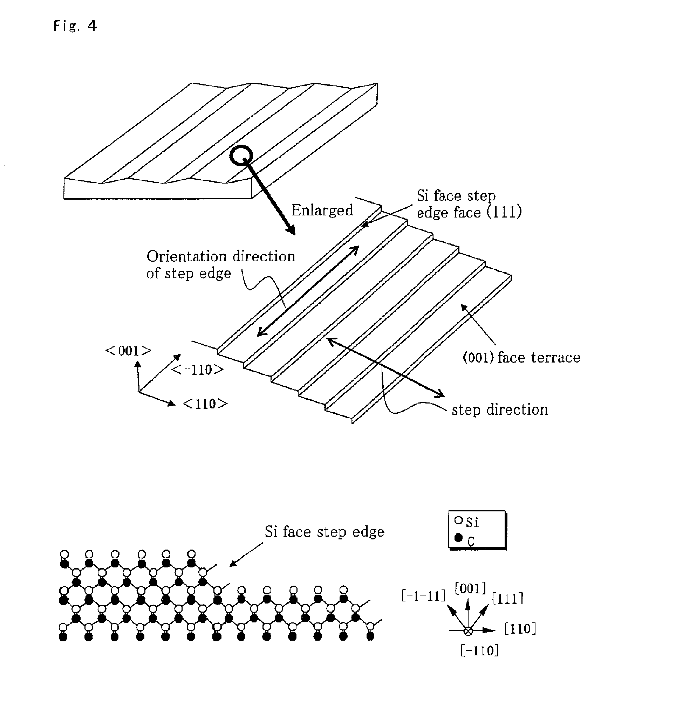

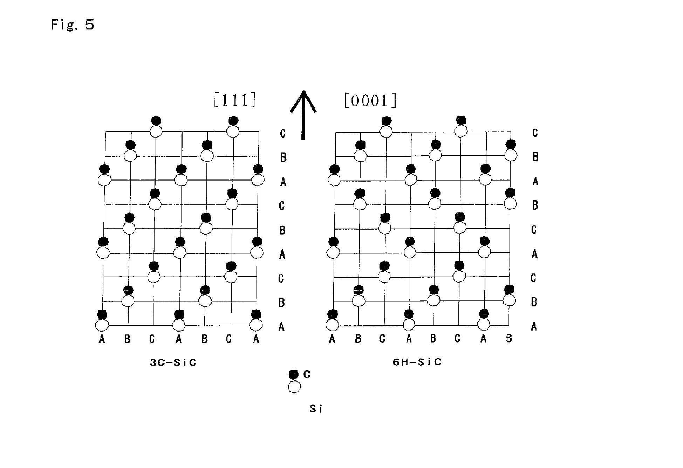

The single-crystal silicon carbide is a one-to-one combination of silicon and carbon in which they are cyclically arranged. Cubic silicon carbide has a structure in which close hexagonal faces comprised of carbon-silicon pairs are stacked with a three-layer period in the <111> direction (see Fig. 4). Hexagonal silicon carbides have a structure in which close hexagonal faces of carbon-silicon pairs are stacked with every possible monotonic period excluding a three-layer period in the <0001> direction. Denoting the three inequivalent positions in which the hexagonal close packed faces of carbon-silicon pairs can be arranged as A, B, and C, the stacked structure of hexagonal silicon carbide can be denoted as ...ABCABC... Additionally, the stacked structure of hexagonal silicon carbide comes in infinite combinations of ...ABABABAB... (2H-SiC), ...ABACABAC... (4H-SiC), ...ABCACBABCACB... (6H-SiC), ...ABCABACBABCABA... (8H-SiC), and the like (see Fig. 5).

In both cubic and hexagonal silicon carbide, the surface is classified as being either a nonpolar face or a polar face. The term "nonpolar face," in terms of an ideal face in which no defects or the like are present, means a face in which the probability of either carbon or silicon being exposed on the surface is identical. Conversely, a "polar face" is defined as a face in which the probability of exposure of carbon on the surface is not equal to that of silicon (for example, the case where unbonded Si atoms are preferentially exposed on the surface when there is a cleavage is referred to as an Si face).

Since defects and the like are present in an actual crystal face, partial nonpolar faces are included among polar faces.

In 3C-SiC cubic silicon carbide, the {111} faces are polar faces and all faces (infinitely present) except for the {111} faces are nonpolar faces. Generally, the {001} faces and the {110} faces are regarded as typical low-order nonpolar faces. As specific examples, (001) and (110) are nonpolar faces; (111), (1-1-1), (-11-1), and (-1-11) are Si polar faces; and (-111), (1-11), (11-1), and (-1-1-1) are C polar faces.

In hexagonal SiC, the {0001} faces are polar faces and all faces (infinitely present) except for the {0001} faces are nonpolar faces. Generally, the {11-20} faces, {1-100} faces, and {03-38} faces are examples of actual low-order nonpolar faces.

In Form A, the junction surface of the semiconductor substrate surface and the gate insulating film is macroscopically parallel to a nonpolar face and microscopically comprised of the nonpolar face and polar faces, with either an Si face or a C face being dominant in the polar faces.
In the present specification, the term "microscopically" means, for example, noticeable on the scale of the atom, and "macroscopically" means noticeable on a scale exceeding several tens of micrometers. As a separate notation, "microscopically" can be interpreted as being on the level of the atom, and "macroscopically" as being the average of the entire junction surface. Accordingly, in Form A, when looking at the junction surface on a scale of several ten micrometers, the junction surface is a face parallel to the nonpolar face, and when looking at the junction surface on the scale of the atom, the junction surface is comprised of a nonpolar face and polar faces, and an Si face or a C face is dominant in the polar face. In other words, a polar face in the form of an Si face or a C face is dominantly present on the order of the atom in addition to a nonpolar face in the junction surface. However, when the field of vision is expanded into a whole, the junction surface is parallel to the nonpolar face. A specific example is the case where protrusions are fabricated in a specific direction on the silicon carbide substrate surface where the surface is the nonpolar face. In that case, a polar face in the form of either a C face or an Si face is present in a microscopically dominant manner (a nonpolar face may also be present depending on the incline of the protrusions), resulting in a macroscopically nonpolar face. Accordingly, to say that the macroscopic surface was the Si face or the C face would mean that it was the {111} faces (that is, the polar faces). However, devices including such junction surfaces lie outside the scope of the present invention.

As set forth above, the 3C-SiC {001} faces are nonpolar faces, and the macroscopic surface of the 3C-SiC {001} faces are always nonpolar faces. Accordingly, this macroscopic surface does not match the polarity of the overall microscopic surface. Since "coarseness" exists on an actual macroscopic surface, when not specifically controlled, either an Si face or a C face appears on the surface in addition to nonpolar face. By contrast, in the present invention, the microscopic polar faces are controlled so that only an Si face or a C face appears on the surface.

Specifically, the polarity control on the surface, that orients the Si face or C face exclusively on the surface, is enabled by aligning unisotropic recessions and protrusions (steps) into a specific direction in order to cause the coareseness . The polarity of the steps is strongly affected by orientation of the steps in between <110> and <1-10> directions.. The present invention strictly determines the polarity of the step edges into Si face or C face. That is, when all of the steps are oriented in the <110> directions, the polarity that is exposed is unified with the Si face, and when oriented in the <-110> directions, it is unified with the C face.

The present inventors thought that the object of the present invention could theoretically be achieved by manipulating the porality at just the junction into a specific one bringing into unity with that polar face. However, as of the present, there is no known method of manipulating the polar face of the junction surface. Accordingly, there is inevitably no known way of forming a junction surface having a unified polar face. Accordingly, in the present invention, in the case of 3C-SiC nonpolar {001} faces, specific polar face among various polar and non-polar faces are exclusively expanded. Finally, even with the nonpolar {001} faces, it is possible to obtain a smooth interface as well as the course of employing conventional polar faces as the surface.

In the present invention, a microscopic surface (partial polar face) is necessarily present. Accordingly, devices having a silicon carbide surface (junction surface) that does not comprise surface steps (for example, coarseness on an atomic level) are not covered by the present invention.

In the case of 3C-SiC, the slopes of the protrusions are oriented in the [110] direction and the [-1-10] direction to obtain a microscopic surface with Si polarity. The slopes of the protrusions are oriented in the [-110] direction and the [1-10] direction to obtain a microscopic surface with C polarity. In the case of the (110) face, C faces and Si faces are exposed keeping opposite configuration when approximately parallel "protrusions" are provided. Thus, a slight miss-orientation in the [001] direction is imparted to obtain Si polarity, and a slight miss-orientation in the [00-1] direction is imparted to obtain C polarity.

In the case of hexagonal SiC (11-20) face, Si polarity can be obtained by inclining the normal axis into [0001] or [1-100] directions, while C polarity can be obtained by inclining into [000-1] or [-1100] directions.
In the case of hexagonal (1-100) face, Si polarity can be obtained by inclining the normal axis into [0001] or [11-20] directions, while C polarity in the [000-1] or [-1-120] directions.
For the hexagonal (03-38) face, Si polarity can be obtained at slopes oriented in the [01-10] direction or [0-110] direction, and C polarity can be obtained at slopes oriented in the [1010] direction or the [-10-10] direction.

In Form B, the junction surface of the semiconductor substrate surface and the gate insulating film comprises terrace faces and step edges oriented in a specific direction. The terrace faces are nonpolar faces and the step edges are comprised of polar faces that are either Si faces or C faces. Terrace faces and step edges are exposed on the junction surface. The step edges are oriented in a specific direction. Since the step edges are oriented in a specific direction, even when the step edges are polar faces, they are either Si faces or C faces. The polar faces, nonpolar faces, and step edge orientation are the same as in Form A.

In Forms A and B, the ratio of the area occupied by the one type of polar face on the junction surface -- that is, in Form A, the ratio of the area occupied by the dominant polar surface -- can fall within a range of 0.75 to 1 when the area of all polar faces in the junction surface is denoted as 1. For example, when the one type of polar face (the dominant polar face) is the Si face, (the area of Si faces)/(the area of Si faces + the area of C faces in the junction surface) can fall within a range of 0.75 to 1. This ratio desirably falls within a range of 0.8 to 1, preferably within a range of 0.9 to 1.

In Form C, the junction surface of the semiconductor substrate surface and the gate insulating film comprises terrace faces, and step edges oriented in a specific direction. The terrace faces are nonpolar faces. The terrace faces have a ratio of the width in the in-plane direction orthogonal to the step direction (the direction of orientation of the step edges) to the width in the step direction (the substrate in-plane direction that is orthogonal to the direction of orientation of the step edges) that is ten-fold or greater. The facts that the junction surface comprises terrace faces, step edges oriented in a specific direction and the terrace faces are nonpolar faces are identical to Form B. Further, the ratio of the width of the terrace faces in the direction of orientation of the step edges to the width in the in-plane direction orthogonal to the direction of orientation of the step edges gives a criterion of the density of the steps and the width of the terrace faces. The fact that it is 10-fold or greater means that the ratio of the area occupied by a specific polar face to the overall surface area is high. The ratio of the width in the direction of orientation of the step edges to the width in the substrate in-plane direction orthogonal to the direction of orientation of the step edges is desirably 10-fold or greater, preferably 30-fold or greater.

In Forms B and C, the width of the terrace faces (the width in the substrate in-plane direction orthogonal to the direction of orientation of the step edges) can be, for example, 0 to 100 nm, and desirably falls within a range of 0 to 20 nm.

In Form D, the junction surface of the semiconductor substrate surface and the gate insulating film is macroscopically parallel to a nonpolar surface, comprises step edges oriented in a specific direction, with the height of the step edges (the height along the direction normal to the substrate surface) falling within a range of 0.5 to 10 nm. The fact that the junction surface is macroscopically parallel to a nonpolar surface is identical to Form A. The fact that the junction surface comprises step edges that are oriented in a specific direction, with the height of the step edges falling within a range of 0.5 to 10 nm, means that minute step edges that are oriented in a specific direction are present on the macroscopic nonpolar surface. The height of the step edges desirably falls within a range of 0.5 to 3 nm.

With the exception that the junction surface of the semiconductor substrate surface and the gate insulating film of semiconductor device 1 is the junction surface of the semiconductor substrate surface and an electrode, semiconductor device 2 is identical to Forms A to D.

### [The method for manufacturing a semiconductor device]

The semiconductor device of the present invention employs a substrate manufactured by a method for manufacturing a semiconductor substrate comprising the steps of: preparing a silicon carbide semiconductor substrate having at least one dominant surface that is a nonpolar face; forming steps oriented in a specific direction on at least a portion of a nonpolar face of the semiconductor substrate; and unifying the polarity of the step edge face with a specific polar face. In the case of semiconductor device 1, a gate insulating film and a gate electrode are provided in the portion that is unified with the specific polar face, and in the case of semiconductor device 2, an electrode is provided therein to complete manufacturing. The positioning of the gate insulating film and gate electrode in the case of semiconductor device 1 and the positioning of the electrode in the case of semiconductor device 2 can be determined by existing methods.

The method for manufacturing a semiconductor device of the present invention will be described below for a semiconductor device in which the carriers are electrons, taking the example of a form in which a homoepitaxial layer is provided on a single-crystal cubic silicon carbide substrate.

A cubic silicon carbide thin film with a carrier concentration of about 7 x 10¹⁵/cm³ is homoepitaxially grown on an n-type single-crystal cubic silicon carbide substrate with a carrier concentration of about 1 x 10¹⁹/cm³. The conducting type of the homoepitaxial layer is adjusted as n-type by nitrogen or phosphorus doping when a Schottky barrier diode, vertical MOSFET, or MESFET is desired, and is turned to p-type by adding aluminum or boron when a lateral MOSFET is desired. The thickness of the homoepitaxially grown silicon carbide layer can be adjusted the duration of homoepitaxial growth, and is suitably selected within a range of 0.5 to 50 micrometers, for example, based on the breakdown voltage of the desired device. So long as the effect of the present invention is achieved, the homoepitaxial growth conditions are not specifically limited. However, by way of example, the conditions shown in Table 1 can be employed.

[Table 1]

**Table 1 Cubic silicon carbide homoepitaxial growth conditions**

| | |
|---|---|
| Growth temperature (°C) | 1,300 to 1,630 |
| SiH₄ flow rate (sccm) | 10 to 50 |
| C₃H₈ flow rate (sccm) | 8 to 40 |
| NH₃ flow rate (sccm) | 1 to 10 |
| H₂ flow rate (slm) | 1 to 5 |
| Pressure (Torr) | 0.001 to 20 |

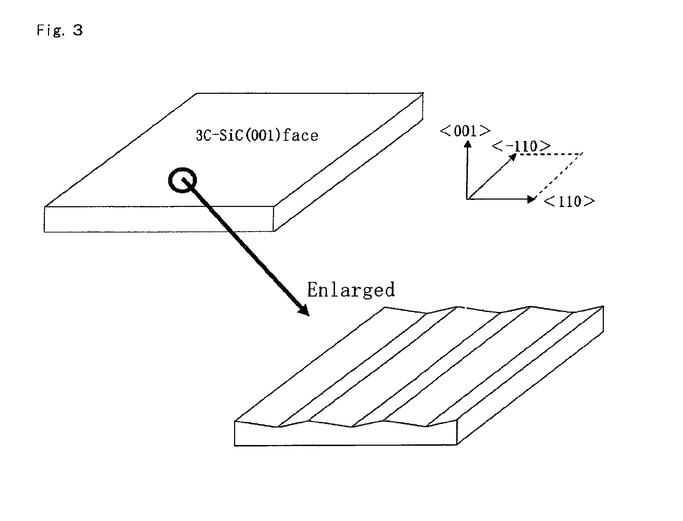

Next, protrusions approximately parallel to the <-110> directions are provided on the cubic silicon carbide thin film surface. The method used to provide the protrusions is not specifically limited. By way of example, diamond slurry with 0.5 to 30 micrometers in diameter can be employed to form abundant polishing grooves approximately parallel to the <-110> directions, or combination of lithographic techniques and dry etching techniques can be employed to provide a line-and-space pattern that is parallel to the <-110> directions. In either case, the cubic silicon carbide thin-film surface is covered with protrusions that are approximately parallel to the <-110> directions and have slopes oriented in the opposing specific {111} planes shown in Fig. 3. However, the difference in height of the protrusions is kept to 10 nm or less.

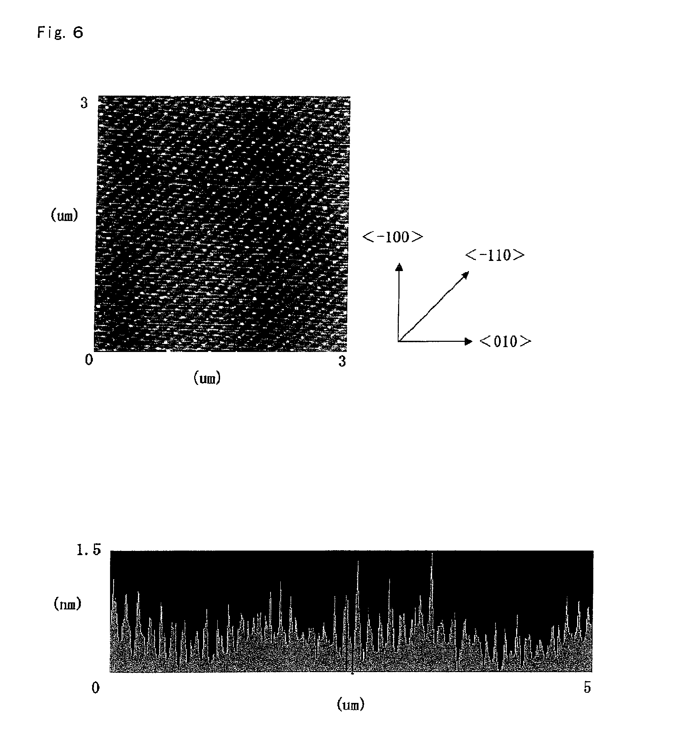

Next, following cleaning by the RCA method, that is cleaning with an ammonia-hydrogen peroxide aqueous solution, the substrate is immersed in a dilute hydrofluoric acid solution for about 5 minutes and rinsed (washed) with deionized water for about 5 minutes to completely remove the native oxide film. Subsequently, the cubic silicon carbide substrate is immersed in a 350 to 600°C molten KOH or molten NaOH melt to unify all of the inclined step edge faces of the protrusions with a specific polarity. In addition to the molten KOH, for example, the cubic silicon carbide substrate is annealed in hydrogen gas in a furnace at 600°C or lower for from one to several tens of minutes. During this process, a gas in the form of hydrogen in an inert gas consisting of 50 percent hydrogen (volumetric ratio) or more at atmospheric pressure is applied in the furnace. The atomic force microscope (AFM) image of the surface that has been treated with hydrogen is as shown in Fig. 6. A steplike pattern parallel to the <-110> directions appears. The height of the steps (height of the step edges) parallel to the <-110> directions is 0.5 nm, which corresponds to the height of two Si-C mono-layers. The step edge faces are all united with a specific polarity. They are united with either an Si face or a C face.

The step of unifying the polarity of the step edge faces with a specific polar face can be a hydrogen reduction treatment step such as that set forth above. Alternatively, the step of unifying the polarity of the step edge faces with a specific polar face can be an alkali treatment step. Methods based on alkali treatment are set forth in the embodiments.

Nickel, platinum, gold, or the like can be deposited on the cubic silicon carbide surface that has been treated to impart a specific polarity and it can be processed to impart a prescribed electrode shape to form a Schottky barrier diode based on the present invention. In the fabrication of a MOSFET, following the formation of a gate insulating film, a donor impurity (nitrogen, phosphorus, or the like) is introduced into the source and drain regions. Next, electrodes of nickel, aluminum, polycrystalline silicon, or the like are positioned in these regions to form the desired structure. In the formation of the gate insulating film, the silicon carbide surface can be oxidized thermally in an oxidizing atmosphere, or an insulating film can be deposited by CVD. Alternatively, the silicon carbide substrate can be heated while immersed in nitric acid (aqueous solution) to induce boiling, and a uniform SiO₂ coating can be formed on the silicon carbide substrate. In either case, the thickness of the gate insulating film, which is determined with the designed threshold voltage and breakdown voltage of the desired semiconductor device in mind, is adjusted by controlling the processing time to within from 10 to several tens of nm.

By forming a semiconductor device by imparting a polarity to the (001) nonpolar face of cubic silicon carbide as set forth above, for example, not only is it possible to obtain desirable device characteristics in the form of a high breakdown voltage and low power consumption, it is also possible to obtain a semiconductor device with good long-term stability. The same applies when employing hexagonal silicon carbide.

### Embodiments

The present invention will be described below based on embodiments and reference examples.

### <Embodiment 1>

A Ni/3C-SiC Schottky diode was fabricated according to the present invention. First, CVD was used to grow an n-type homoepitaxial layer with a carrier concentration of 3.0 x 10¹⁵/cm³ on the (001) face of an n-type single-crystal cubic silicon carbide substrate with a carrier concentration of 3.0 x 10¹⁸/cm³. The growth conditions were in accordance with Table 2. The thickness of the film grown was adjusted by controlling the growing time.

[Table 2]

**Table 2 Conditions of homoepitaxial growth on single-crystal cubic silicon carbide substrate**

| | |
|---|---|
| Growth temperature (°C) | 1,600 |
| SiH₄ flow rate (sccm) | 30 |
| C₃H₈ flow rate (sccm) | 17 |
| NH₃ flow rate (sccm) | 1 |
| H₂ flow rate (slm) | 2 |
| Pressure (Torr) | 10 |
| Thickness of film grown (micrometers) | 15 |

Next, diamond slurry with 1 micrometer in diameter were used to form abundant polishing grooves approximately parallel to the [-110] direction on the surface of the homoepitaxially grown cubic silicon carbide thin film. This step formed protrusions with the (111) face and (-1-11) face as missoriented directions on the surface of the cubic silicon carbide thin film. However, following the polishing stage, there were disordered surfaces in addition to the ideal faces ({100} and {111} faces). The peak-valley height of the protrusions was about 2 nm, and the average distance between protrusion peaks was 1 micrometer.

Next, to remove the crystal defect layer generated on the silicon carbide surface by the polishing groove generating step, thermal oxidation was conducted in a dry oxygen atmosphere at 1,100°C for 60 minutes, after which the thermal oxide film was removed by etching in 5 percent HF for 10 minutes. This step retained the original shape of the protrusions while uniformly removing a region of 15 nm on the silicon carbide surface.

Next, the substrate surface was cleaned under the conditions indicated in Table 3, immersed in dilute hydrofluoric acid solution for about 5 minutes, and then rinsed (cleaned) in deionized water for about 5 minutes to completely remove the native oxide film.

[Table 3]

**Table 3 Substrate surface cleaning conditions**

| | |
|---|---|
| 1 | H₂SO₄ + H₂O₂ -> 1:1 mixing 5 min (80 - 90°C) |
| 2 | DI (deionized water)/US (ultrasonic cleaning) -> 1 min |
| 3 | NH₄OH + H₂O₂ + H₂O -> 1:1:5 mixing 5 min (80°C) |
| 4 | DI/US -> 1 min |
| 5 | HF (0.5%) -> 5 min (room temperature) |
| 6 | DI/US -> 1 min |
| 7 | HCl + H₂O₂ + H₂O -> 1:1:6 5 min (80°C) |
| 8 | DI/US -> 1 min |
| 9 | HF (0.5%) -> 1 min (room temperature) |
| 10 | DI/US->1min |
| 11 | drying |

Subsequently, the cubic silicon carbide substrate was annealed in a 100 percent hydrogen atmosphere at atmospheric pressure at 400°C for 300 minutes to form a step pattern having a step edge face parallel to the [-110] direction. As shown in Fig. 6, the step pattern was periodic. The step height was 0.5 to 0.6 nm, corresponding to the height of two Si-C mono-layers. Since the step edge faces had a step shape that was parallel to the [-110] direction, they were all unified with Si polarity. The steps that were parallel to the [-110] direction had step edge faces that were oriented in the [111] direction, and were necessarily Si polar faces. That is, it was confirmed the fact that faces that were exposed on the surface following polishing and the disordered portion had been eliminated, the fact that steps with ideal faces had been formed and the fact that the polarity had been unified.

Next, a stencil mask having round windows 200 micrometers in diameter made of stainless steel was, placed on the surface of the homoepitaxial cubic silicon carbide film of unified Si polarity and a 100 nm thickness of nickel was deposited by electron beam evaporation technique. Finally, a 100 nm thickness of nickel was deposited by electron beam evaporation technique over the entire surface on the back side of the n-type single-crystal cubic silicon carbide substrate to fabricate a Ni/3C-SiC Schottky diode.

### <Embodiment 2>

A Ni/3C-SiC Schottky diode was fabricated according to the present invention.
Diamond slurry 1 micrometer in diameter were used to form abundant polishing grooves that were approximately parallel to the [110] direction on the surface of a cubic silicon carbide thin film that had been homoepitaxially grown using the same substrate, method, and conditions as in Embodiment 1. With this step, the surface of the cubic silicon carbide thin film was covered with protrusions with the (-111) and (1-11) faces as missoriented directions. However, following the polishing stage, there were disordered surfaces in addition to the ideal faces. The peak-valley height of the protrusions was about 2 nm, and the average distance between protrusion peaks was 1 micrometer.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a hydrogen atmosphere at atmospheric pressure by the same method and under the same conditions as in Embodiment 1 to form a step pattern having a step edge face parallel to the [110] direction. As shown in Fig. 6, the step pattern was arranged periodic. The step height was 0.5 to 0.6 nm, corresponding to the height of two Si-C mono-layers. Since the step edge faces had a step shape that was parallel to the [110] direction, they were all unified with C polarity. The steps that were parallel to the [110] direction had step edge faces that were oriented in the [1-11] direction, and became C polar faces principally. That is, the confirmed were the fact that faces that were exposed on the surface following polishing and the disordered portion had been eliminated, the fact that steps with ideal faces had been formed, and the fact that the polarity had been unified.

Next, a 100 nm thickness of nickel was deposited by the same method and under the same conditions as in Embodiment 1 on the surface of the homoepitaxial cubic silicon carbide film that had been unified with C polarity, and a 100 nm thickness of nickel was evaporated over the entire surface on the back side of the n-type single-crystal cubic silicon carbide substrate to fabricate a Ni/3C-SiC Schottky diode.

### <Reference Example 1>

A Ni/3C-SiC Schottky diode was fabricated by the following process as a reference example of the present invention. Diamond slurry 1 micrometer in diameter were used to form abundant polishing grooves that were approximately parallel to the [100] direction on the surface of a cubic silicon carbide thin film that had been homoepitaxially grown using the same substrate, method, and conditions as in Embodiment 1. With this step, the surface of the cubic silicon carbide thin film was covered with protrusions with the (110) and (-1-10) faces as missoriented directions. However, following the polishing stage, there were disordered surfaces in addition to the ideal faces. The peak-valley height of the protrusions was about 2 nm, and the average distance between protrusion peaks was 1 micrometer.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a hydrogen atmosphere at atmospheric pressure by the same method and under the same conditions as in Embodiment 1. However, periodic steps such as those shown in Fig. 6 did not appear. Irregular steps of nonuniform height appeared. Based on this fact, it was determined that the steps that appeared simultaneously consisted of both Si polarity and C polarity.

Next, by the same method and under the same conditions as in Embodiment 1, a 100 nm thickness of nickel was deposited on the surface, after which a 100 nm thickness of nickel was evaporated over the entire surface on the back side of the n-type single-crystal cubic silicon carbide substrate to fabricate a Ni/3C-SiC Schottky diode.

### <Reference Example 2>

A Ni/3C-SiC Schottky diode was fabricated by the following process as a reference example of the present invention. An n-type homoepitaxial layer was grown using the same substrate, method, and conditions as in Embodiment 1.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a hydrogen atmosphere at atmospheric pressure by the same method and under the same conditions as in Embodiment 1. However, steps such as those shown in Fig. 6 did not appear. The surface was discovered to be smooth.

Next, by the same method and under the same conditions as in Embodiment 1, a 100 nm thickness of nickel was deposited on the surface by electron beam evaporation technique, after which a 100 nm thickness of nickel was evaporated over the entire surface on the back side of the n-type single-crystal cubic silicon carbide substrate to fabricate a Ni/3C-SiC Schottky diode.

### <Reference Example 3>

A Ni/3C-SiC Schottky diode was fabricated by the following process as a reference example of the present invention. Abundant polishing grooves that were approximately parallel to the [-110] direction were formed in the same manner as in Embodiment 1 on the surface of a cubic silicon carbide thin film that had been homoepitaxially grown using the same substrate, method, and conditions as in Embodiment 1. This formed protrusions with the (111) and (-1-11) faces as missorientations on the surface of the cubic silicon carbide thin film. However, following the polishing stage, there were disordered surfaces in addition to the ideal faces. The peak-valley height of the protrusions was about 2 nm, and the average distance between protrusion peaks was 1 micrometer.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Periodic steps such as those shown in Fig. 6 did not appear on the surface. Irregular steps of nonuniform height appeared. Based on this fact, it was determined that the steps that appeared simultaneously consisted of both Si polarity and C polarity.

Next, by the same method and under the same conditions as in Embodiment 1, a 100 nm thickness of nickel was deposited on the surface, after which a 100 nm thickness of nickel was evaporated over the entire surface on the back side of the n-type single-crystal cubic silicon carbide substrate to fabricate a Ni/3C-SiC Schottky diode.

### <Embodiment 3>

A Pt/3C-SiC Schottky diode was fabricated according to the present invention. Abundant polishing grooves that were approximately parallel to the [-110] direction were formed in the same manner as in Embodiment 1 on the surface of a cubic silicon carbide thin film that had been homoepitaxially grown using the same substrate, method, and conditions as in Embodiment 1. This formed protrusions with the (111) and (-1-11) faces as missoriented directions on the surface of the cubic silicon carbide thin film. However, following the polishing stage, there were disordered surfaces in addition to the ideal faces. The peak-valley height of the protrusions was about 2 nm, and the average distance between protrusion peaks was 1 micrometer.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a hydrogen atmosphere at atmospheric pressure by the same method and under the same conditions as in Embodiment 1 to form a step pattern having a step edge face aligned in the [-110] direction. As shown in Fig. 6, the step pattern was periodic. The step height was 0.5 to 0.6 nm, corresponding to the height of two Si-C mono-layers. The step edge faces were all unified with Si polarity in the same manner as in Embodiment 1. That is, the confirmed were the fact that faces that were present on the surface following polishing and the disordered portion had been eliminated, the fact that steps with ideal faces had been formed, and the fact that the polarity had been unified.

Next, by the same method and under the same conditions as in Embodiment 1, a 100 nm thickness of platinum was deposited on the surface of the homoepitaxial cubic silicon carbide film that had been unified with Si polarity, after which a 100 nm thickness of nickel was evaporated over the entire surface on the back side of the n-type single-crystal cubic silicon carbide substrate to fabricate a Pt/3C-SiC Schottky diode.

### <Embodiment 4>

A Pt/3C-SiC Schottky diode was fabricated according to the present invention. Abundant polishing grooves that were approximately parallel to the [110] direction were formed in the same manner as in Embodiment 2 on the surface of a cubic silicon carbide thin film that had been homoepitaxially grown using the same substrate, method, and conditions as in Embodiment 1. This formed protrusions with the (-111) and (1-11) faces as missoriented directions on the surface of the cubic silicon carbide thin film. However, following the polishing stage, there were disordered surfaces in addition to the ideal faces. The peak-valley height of the protrusions was about 2 nm, and the average distance between protrusion peaks was 1 micrometer.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a hydrogen atmosphere at atmospheric pressure by the same method and under the same conditions as in Embodiment 1 to form a step pattern having a step edge face parallel to the [110] direction. As shown in Fig. 6, the step pattern was arranged periodically. The step height was 0.5 to 0.6 nm, corresponding to the height of two Si-C mono-layers. The step edge faces were all unified with C polarity in the same manner as in Embodiment 2. That is, the confirmed were the fact that faces that were exposed on the surface following polishing and the disordered portion had been eliminated, the fact that steps with ideal faces had been formed, and the fact that the polarity had been unified.

Next, by the same method and under the same conditions as in Embodiment 1, a 100 nm thickness of platinum was deposited on the surface of the homoepitaxial cubic silicon carbide film that had been unified with C polarity, after which a 100 nm thickness of nickel was evaporated over the entire surface on the back side of the n-type single-crystal cubic silicon carbide substrate to fabricate a Pt/3C-SiC Schottky diode.

### <Reference Example 4>

A Pt/3C-SiC Schottky diode was fabricated by the following process as a reference example. Abundant polishing grooves that were approximately parallel to the [100] direction were formed in the same manner as in Embodiment 2 on the surface of a cubic silicon carbide thin film that had been homoepitaxially grown using the same substrate, method, and conditions as in Embodiment 1. This formed protrusions with the (110) and (-1-10) faces as missoriented direction. However, following the polishing stage, there were disordered surfaces in addition to the ideal faces. The peak-valley height of the protrusions was about 2 nm, and the average distance between protrusion peaks was 1 micrometer.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a hydrogen atmosphere at atmospheric pressure by the same method and under the same conditions as in Embodiment 1. However, periodic steps such as those shown in Fig. 6 did not appear. Irregular steps of nonuniform height appeared. Based on this fact, it was determined that the steps that appeared simultaneously consisted of both Si polarity and C polarity.

Next, by the same method and under the same conditions as in Embodiment 1, a 100 nm thickness of platinum was deposited on the surface, after which a 100 nm thickness of nickel was evaporated over the entire surface on the back side of the n-type single-crystal cubic silicon carbide substrate to fabricate a Pt/3C-SiC Schottky diode.

The Schottky electrode on the surface of the homoepitaxial cubic silicon carbide film was employed as anode and the nickel electrode on the back side of the single-crystal cubic silicon carbide substrate was employed as cathode in the 3C-SiC Schottky diodes fabricated in Embodiments 1 to 4 and Reference Examples 1 to 4 above, and current-voltage characteristics were measured at room temperature. The Schottky barrier height was calculated based on the trends of forward direction characteristics using extrapolated values for ideality factor n at 0 V. The leakage current density was measured at breakdown voltage and for 100 V based on reverse direction characteristics. These characteristics have been summarized in Table 4.

[Table 4]

**Table 4 A comparison of the characteristics of Ni/3C-SiC Schottky barrier diodes**

| | Polar face | Schottky electrode | Ideality factor | Barrier height (eV) | Reverse direction breakdown voltage (V) | Leakage current density (100 V applied in reverse direction) (A/cm²) |
|---|---|---|---|---|---|---|
| Embodiment 1 | Si face | Ni | 1.06 | 0.64 | 480 | 1.4 x 10⁻⁷ |
| Embodiment 2 | C face | | 1.13 | 0.63 | 340 | 8.1 x 10⁻⁷ |
| Ref. Ex. 1 | Mixed | | 1.77 | 0.29 | 135 | 1.4 x 10⁻⁵ |
| Ref. Ex. 2 | Mixed | | 1.69 | 0.27 | 115 | 3.2 x 10⁻³ |
| Ref. Ex. 3 | Mixed | | 1.82 | 0.34 | 154 | 4.8 x 10⁻⁵ |
| Embodiment 3 | Si face | Pt | 1.02 | 0.82 | 590 | 8.3 x 10⁻⁶ |
| Embodiment 4 | C face | | 1.10 | 0.79 | 533 | 1.4 x 10⁻⁷ |
| Ref. Ex. 4 | Mixed | | 1.52 | 0.55 | 328 | 6.2 x 10⁻⁶ |

Based on the above results, the present invention prevents undesirable generation of electric field, reduces the crystal defect density, and realizes a stable Schottky barrier as determined by the metal work function and electron affinity of silicon carbide by uniting the polarity of the edge faces of the interface of the Schottky electrode, permitting the manufacturing of a device with a desired breakdown voltage. Further, good rectifying properties are clearly imparted by reducing current components other than thermal diffusion due to defects in the Schottky interface, such as recombination centers or leakage current caused by nonuniformity and the like in the barrier height due to the presence of an interface electric dipole. This information also applies to the process of fabricating MESFETs. It is evident that the present invention achieves high breakdown voltages and low leakage currents.

### <Embodiment 5>

A MOS diode was fabricated according to the present invention.
Abundant polishing grooves that were approximately parallel to the [-110] direction were formed in the same manner as in Embodiment 1 on the surface of a cubic silicon carbide thin film that had been homoepitaxially grown using the same substrate, method, and conditions as in Embodiment 1. This formed protrusions with the (111) and (-1-11) faces as missoriented directions. However, following the polishing stage, there were disordered surfaces in addition to the ideal faces. The peak-valley height of the protrusions was about 2 nm, and the average distance between protrusion peaks was 1 micrometer.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a hydrogen atmosphere at atmospheric pressure by the same method and under the same conditions as in Embodiment 1 to form a step pattern having a step edge face parallel to the [-110] direction. As shown in Fig. 6, the step pattern was periodic. The step height was 0.5 to 0.6 nm, corresponding to the height of two Si-C mono-layers. The step edge faces were all unified with S polarity.

A thermal oxide film was then formed to a thickness of 45 to 55 nm on the surface of the cubic silicon carbide by thermal oxidation in a dry oxygen atmosphere at 1,000°C for 600 minutes.

Next, a 100 nm thickness of nickel was deposited by the same method and under the same conditions as in Embodiment 1 on the surface of the homoepitaxial cubic silicon carbide film on which the thermal oxide film had been formed. Further, a 100 nm thickness of nickel was evaporated over the entire surface on the back side of the n-type single-crystal cubic silicon carbide substrate to fabricate a MOS diode array on a 20 mm square shape of the silicon carbide substrate.

### <Reference Example 5>

A MOS diode was fabricated by the following process as a reference example for Embodiment 5.
An n-type epitaxial layer was grown using the same substrate, methods, and conditions as in Embodiment 1.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a hydrogen atmosphere at atmospheric pressure by the same method and under the same conditions as in Embodiment 1. However, the surface was smooth and no steps indicating a specific polar face were observed.

A thermal oxide film was then formed to a thickness of 45 to 55 nm on the surface of the cubic silicon carbide by thermal oxidation in a dry oxygen atmosphere at 1,000°C for 600 minutes.

Next, by the same method and under the same conditions as in Embodiment 1, a 100 nm thickness of nickel was deposited on the surface of the homoepitaxial cubic silicon carbide film on which the thermal oxide film had been formed. Further, a 100 nm thickness of nickel was evaporated over the entire surface on the back side of the n-type single-crystal cubic silicon carbide substrate to fabricate a MOS diode array on a 20 mm square shape of the silicon carbide substrate.

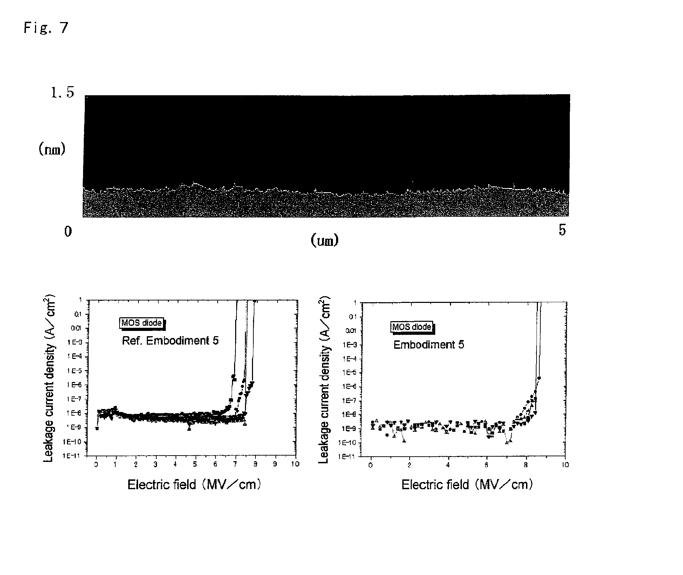

The oxide film thickness was determined by measurement of the oxide film capacitance and the breakdown voltage was determined by current-voltage measurement for the MOS diode arrays fabricated in Embodiment 5 and Reference Example 5. The results of the breakdown voltage measurement of the MOS diodes are given in Fig. 7. The oxide film thickness of the embodiment was 53 nm and that of the reference example was 47 nm. Current-voltage measurement was conducted for all the diodes constituting the array. The oxide film dielectric breakdown field strength and standard deviation thereof were calculated on that basis. The results are given in Table 5.

[Table 5]

**Table 5 A comparison of MOS diodes**

| | Polarity of MOS interface | Thickness of oxide film (nm) | Oxide film dielectric breakdown field strength ± standard deviation (MV/cm) |
|---|---|---|---|
| Embodiment 5 | Si face | 53 | 8.5 ± 0.1 |
| Ref. Example 5 | Mixed | 47 | 7.4 ± 0.4 |

Table 5 reveals the following. Despite identical thermal oxidation conditions, Embodiment 5, with a surface polarity unified with the Si face, exhibited a higher oxidation rate than Reference Example 5. Embodiment 5, with a polarity unified with the Si face, exhibited a higher field strength and better uniformity (a lower standard deviation) than Reference Example 5 in terms of dielectric breakdown field strength. This shows that by unifying the polarity of the cubic silicon carbide surface before forming the oxide film, it was possible to form a uniform oxide film over a wide area without being affected by differences in oxidation rates due to polarity. This knowledge also applies to the gate oxide films of MOSFETs. Application of the present invention to the MOSFET gate oxide film forming process clearly permits the formation of a uniform gate oxide film over a wide area.

### <Embodiment 6>

An n-channel lateral MOSFET was fabricated according to the present invention. First, a p-type homoepitaxial layer was grown by CVD on the (001) face of an n-type single-crystal cubic silicon carbide substrate with a carrier concentration of 3.0 x 10¹⁸/cm³. The growing conditions were in accordance with Table 6. The thickness of the film grown was adjusted by controlling the growth duration.

[Table 6]

**Table 6 Conditions of epitaxial growth on single-crystal cubic silicon carbide substrate**

| | |
|---|---|
| Growth temperature (°C) | 1,600 |
| SiH₄ flow rate (sccm) | 30 |
| C₃H₈ flow rate (sccm) | 15 |
| AI(CH₃)₃ flow rate (sccm) | 10 |
| H₂ flow rate (slm) | 2 |
| Pressure (Torr) | 10 |
| Thickness of film grown (micrometers) | 20 |

Next, diamond slurry 1 micrometer in diameter were used to form abundant polishing grooves that were approximately parallel to the [-110] direction on the surface of the homoepitaxially grown cubic silicon carbide thin film. This step covered the surface of the cubic silicon carbide thin film with protrusions with the (111) and (-1-11) faces as missoriented directions. However, following the polishing stage, there were disordered surfaces in addition to the ideal faces. The peak-valley height of the protrusions was about 2 nm, and the average distance between protrusion peaks was 1 micrometer.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a hydrogen atmosphere at atmospheric pressure by the same method and under the same conditions as in Embodiment 1 to form a step pattern having step edges aligned in the [-110] direction. As shown in Fig. 6, the step pattern was periodic. The step height was 0.5 nm, corresponding to the height of two Si-C mono-layers. The step edge faces were all unified with Si polarity.

Subsequently, a photolithography step was used to ion implant N in prescribed source and drain regions. The ion implantations were conducted at an implantation temperature of 500°C in three stages of 200 keV, 120 keV, and 70 keV with a total dose of 7 x 10¹³/cm² to form source and drain regions consist of the n-type regions that were 0.5 micrometer in depth and had a concentration of 1 x 10¹⁸/cm³ for the p-type region. Next, an annealing was conducted at 1,650°C for 10 minutes at atmospheric pressure in an Ar atmosphere to activate the N ion-implanted regions. The activation rate was 80 percent.

The above silicon carbide substrate was then heated to boiling after being immersed in a 40 weight percent concentration nitric acid (aqueous solution) at room temperature. The state of boiling was continued to achieve an azeotropic state with a boiling point of 120.7°C and a nitric acid concentration of 68 percent (weight ratio). This azeotropic state was subsequently continued for 5 hours to form a uniform 30 nm oxide coating on the silicon carbide substrate, for use as a gate insulating film.

By photolithographic and etching steps, contact holes were provided in the gate insulating film as source and drain regions and source and drain electrodes and a gate electrode were formed. A TiN electrode 100 nm in thickness with a gate length of 2 micrometers and a gate width of 10 micrometers was employed as the gate electrode. Al 100 nm in thickness was employed as the source and drain electrodes.

Measurement of the drain current-drain voltage characteristics of the diode formed as set forth above using the gate voltage as a parameter revealed a specific on-resistance of 3.5 mΩ(Ohm)·cm² and a maximum channel mobility of 240 cm²/V/s. The facts that the gate threshold voltage was +2.4 V and the transistor was normally missoriented were confirmed. Next, the measurement temperature was changed from 300 K to 500 K to measure the temperature dependency of channel mobility. The channel mobility exhibited a proportional tendency of T^{-2.15} for temperature T, indicating a negative temperature coefficient.

Finally, the electrodes and the gate insulating film were removed with a 50 percent hydrofluoric acid. The center line average roughness of the silicon carbide surface at just under the gate was measured. The roughness along the [-110] direction, with visible atomic steps, was an Ra of 0.5 nm, and the roughness along the [110] direction, in which no atomic steps were visible, was an Ra of about 0.1 nm.

### <Embodiment 7>

An n-channel lateral MOSFET was fabricated according to the present invention. First, a p-type homoepitaxial layer was grown by CVD on the (001) face of an n-type single-crystal cubic silicon carbide substrate with a carrier concentration of 3.0 x 10¹⁸/cm³. The growing conditions were in accordance with Table 6. The thickness of the film grown was adjusted by controlling the growth duration.

Next, diamond slurry 1 micrometer in diameter were used to form abundant polishing grooves that were approximately parallel to the [-110] direction on the surface of the homoepitaxially grown cubic silicon carbide thin film. This step covered the surface of the cubic silicon carbide thin film with protrusions with the (111) and (-1-11) faces as missoriented directions. However, following the polishing stage, there were disordered surfaces in addition to the ideal faces. The peak-valley height of the protrusions was about 2 nm, and the average distance between protrusion peaks was 1 micrometer.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a hydrogen atmosphere at atmospheric pressure by the same method and under the same conditions as in Embodiment 1 to form a step pattern having step edges aligned in the [-110] direction. As shown in Fig. 6, the step pattern was periodic. The step height was 0.5 nm, corresponding to the height of two Si-C mono-layers. The step edge faces were all unified with Si polarity.

Subsequently, a photolithography step was used to ion implant N in prescribed source and drain regions. The ion implantations were conducted at an implantation temperature of 500°C in three states of 200 keV, 120 keV, and 70 keV with a total dose of 7 x 10¹³/cm² to form source and drain regions consist of n-type regions that were 0.5 micrometer in depth and had a concentration of 1 x 10¹⁸/cm³ in the p region. Next, an annealing was conducted at 1,650°C for 10 minutes at atmospheric pressure in an Ar atmosphere to activate the N ion-implanted regions. The activation rate was 80 percent.

Next, a gate insulating film was formed in a dry oxygen atmosphere. In this process, the silicon carbide was oxidized thermally under the conditions in Table 7. A quartz reaction tube was used for the thermal oxidation, oxygen was fed at 3 slm at atmospheric pressure, and processing was conducted at 1,100°C for 60 min. Following processing, the fact that an oxide film 60 nm in thickness had been formed on the silicon carbide surface was confirmed by SIMS depth profile analysis.

[Table 7]

**Table 7 Thermal oxidation conditions**

| | |
|---|---|
| Atmosphere | 100 % oxygen |
| Pressure | Atmospheric pressure |
| Temperature | 1,100°C |
| Time | 60 minutes |

By photolithographic and etching steps, contact holes were provided in the gate insulating film as source and drain regions and source and drain electrodes and a gate electrode were formed. A TiN electrode 100 nm in thickness with a gate length of 2 micrometers and a gate width of 10 micrometers was employed as the gate electrode. Al 100 nm in thickness was employed as the source and drain electrodes.

Measurement of the drain current-drain voltage characteristics of the diode formed as set forth above using the gate voltage as a parameter revealed a specific on-resistance of 5.3 mΩ(OHM)·cm² and a maximum channel mobility of 145 cm²/V/s. The facts that the gate threshold voltage was +2.8 V and the transistor was normally off were confirmed. Next, the measurement temperature was changed from 300 K to 500 K to measure the temperature dependency of channel mobility. The channel mobility exhibited a proportional tendency of T^{-1.82} for temperature T, indicating a negative temperature coefficient.

Finally, the electrodes and the gate insulating film were removed with a 50 percent hydrofluoric acid. The center line average roughness of the silicon carbide surface at just under the gate was measured. The roughness along the [-110] direction, with visible atomic steps, was an Ra of 0.3 to 0.4 nm, while the roughness along the [110] direction, in which no atomic steps were visible, was an Ra of about 0.1 nm.

### <Embodiment 8>

An n-channel lateral MOSFET was fabricated according to the present invention. First, a p-type homoepitaxial layer was grown by CVD on the (001) face of an n-type single-crystal cubic silicon carbide substrate with a carrier concentration of 3.0 x 10¹⁸/cm³. The growing conditions were in accordance with Table 6. The thickness of the film grown was adjusted by controlling the growth duration.

Next, diamond slurry 1 micrometer in diameter were used to form abundant polishing grooves that were approximately parallel to the [110] direction on the surface of the homoepitaxially grown cubic silicon carbide thin film. This step covered the surface of the cubic silicon carbide thin film with protrusions with the (-111) and (1-11) faces as missoriented directions. However, following the polishing stage, there were disordered surfaces in addition to the ideal faces. The peak-valley height of the protrusions was about 2 nm, and the average distance between protrusion peaks was 1 micrometer.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a hydrogen atmosphere at atmospheric pressure by the same method and under the same conditions as in Embodiment 1 to form a step pattern having step edges aligned in the [110] direction. As shown in Fig. 6, the step pattern was periodic. The step height was 0.5 nm, corresponding to the height of two Si-C mono-layers. The step edge faces were all unified with C polarity.

Subsequently, N ion implantation and an annealing were conducted under the same conditions as in Embodiment 7. The activation rate of the N ion implantation regions was 80 percent.

Next, thermal oxidation was conducted for 60 min at 1,150°C in a dry oxygen atmosphere to form a uniform 45 nm oxide film on the silicon carbide substrate. This film was employed as the gate insulating film

By photolithographic and etching steps, contact holes were provided in the gate insulating film as source and drain regions and source and drain electrodes and a gate electrode were formed. A TiN electrode 100 nm in thickness with a gate length of 2 micrometers and a gate width of 10 micrometers was employed as the gate electrode. Al 100 nm in thickness was employed as the source and drain electrodes.

Measurement of the drain current-drain voltage characteristics of the diode formed as set forth above using the gate voltage as a parameter revealed a specific on-resistance of 4.1 mΩ(OHM)·cm² and a maximum channel mobility of 187 cm²/V/s. The facts that the gate threshold voltage was +2.3 V and the transistor was normally off were confirmed. Next, the measurement temperature was changed from 300 K to 500 K to measure the temperature dependency of channel mobility. The channel mobility exhibited a proportional tendency of T^{-2.04} for temperature T, indicating a negative temperature coefficient.

Finally, the electrodes and the gate insulating film were removed with a 50 percent hydrofluoric acid. The center line average roughness of the silicon carbide surface at just under the gate was measured. The roughness along the [110] direction, with visible atomic steps, was an Ra of 0.3 to 0.4 nm, and the roughness along the [-110] direction, in which no atomic steps were visible, was an Ra of about 0.1 nm.

### <Embodiment 9>

An n-channel lateral MOSFET was fabricated according to the present invention. First, a p-type homoepitaxial layer was grown by CVD on the (001) face of an n-type single-crystal cubic silicon carbide substrate with a carrier concentration of 3.0 x 10¹⁸/cm³. The growing conditions were in accordance with Table 6. The thickness of the film grown was adjusted by controlling the growth duration.

Next, diamond slurry 1 micrometer in diameter were used to form abundant polishing grooves that were approximately parallel to the [-110] direction on the surface of the homoepitaxially grown cubic silicon carbide thin film. With this step, the surface of the cubic silicon carbide thin film was covered with protrusions with the (111) and (-1-11) faces as missoriented directions. However, following the polishing stage, there were disordered surfaces the in addition to the ideal faces. The peak-valley height of the protrusions was about 2 nm, and the average distance between protrusion peaks was 1 micrometer.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a hydrogen atmosphere at atmospheric pressure by the same method and under the same conditions as in Embodiment 1 to form a step pattern having step edges aligned in the [-110] direction. As shown in Fig. 6, the step pattern was periodic. The step height was 0.5 nm, corresponding to the height of two Si-C mono-layers. The step edge faces were all unified with Si polarity.

Subsequently, N ion implantation and an annealing were conducted under the same conditions as in Embodiment 7. The activation rate of the N ion implantation regions was 80 percent.

Next, a gate insulating film (oxide film) was formed using the reaction gases SiH₄ and O₂ at a temperature of 650°C using an atmospheric pressure vapor phase growth system. The gas flow ratio was SiH₄/O₂ = 1/10. Treatment for 25 minutes produced an oxide film 60 nm in thickness.

By photolithographic and etching steps, contact holes were provided in the gate insulating film as source and drain regions and source and drain electrodes and a gate electrode were formed. A TiN electrode 100 nm in thickness with a gate length of 2 micrometers and a gate width of 10 micrometers was employed as the gate electrode. Al 100 nm in thickness was employed as the source and drain electrodes.

Measurement of the drain current-drain voltage characteristics of the diode formed as set forth above using the gate voltage as a parameter revealed a specific on-resistance of 3.3 mΩ(OHM)·cm² and a maximum channel mobility of 245 cm²/V/s. The facts that the gate threshold voltage was +3.4 V and the transistor was normally off were confirmed. Next, the measurement temperature was changed from 300 K to 500 K to measure the temperature dependency of channel mobility. The channel mobility exhibited a proportional tendency of T^{-2.0} for temperature T, indicating a negative temperature coefficient.

Finally, the electrodes and the gate insulating film were removed with a 50 percent hydrofluoric acid. The center line average roughness of the silicon carbide surface at just under the gate was measured. The roughness along the [110] direction, with visible atomic steps, was an Ra of 0.3 to 0.4 nm, and the roughness along the [-110] direction, in which no atomic steps were visible, was an Ra of about 0.1 nm.

### <Reference Example 6>

An n-channel lateral MOSFET was fabricated according to the present invention. First, a p-type homoepitaxial layer was grown by CVD on the (001) face of an n-type single-crystal cubic silicon carbide substrate with a carrier concentration of 3.0 x 10¹⁸/cm³. The growing conditions were in accordance with Table 6. The thickness of the film grown was adjusted by controlling the growth duration.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a hydrogen atmosphere at atmospheric pressure by the same method and under the same conditions as in Embodiment 1, but the surface remained smooth and no steps oriented in a specific direction suggesting the presence of a polar face were found.

Subsequently, N ion implantation and an annealing were conducted under the same conditions as in Embodiment 7. The activation rate of the N ion implantation regions was 80 percent.

The silicon carbide substrate was then heated to boiling after being immersed in a 40 weight percent concentration of nitric acid (aqueous solution) at room temperature. The state of boiling was continued to achieve an azeotropic state with a boiling point of 120.7°C and a nitric acid concentration of 68 percent (weight ratio). This azeotropic state was subsequently continued for five hours to form a uniform 30 nm oxide coating on the silicon carbide substrate for use as a gate insulating film.

By photolithographic and etching steps, contact holes were provided in the gate insulating film as source and drain regions and source and drain electrodes and a gate electrode were formed. A TiN electrode 100 nm in thickness with a gate length of 2 micrometers and a gate width of 10 micrometers was employed as the gate electrode. Al 100 nm in thickness was employed as the source and drain electrodes.

Measurement of the drain current-drain voltage characteristics of the diode formed as set forth above using the gate voltage as a parameter revealed a specific on-resistance of 21.4 mΩ(OHM)·cm² and a maximum channel mobility of 36.3 cm²/V/s. The facts that the gate threshold voltage was +1.1 V and the transistor was normally off were confirmed. Next, the measurement temperature was changed from 300 K to 500 K to measure the temperature dependency of channel mobility. The channel mobility exhibited a proportional tendency of T^{-0.41} for temperature T, indicating a negative temperature coefficient.

Finally, the electrodes and the gate insulating film were removed with a 50 percent hydrofluoric acid. The center line average roughness of the silicon carbide surface at just under the gate was measured. The roughness along the [110] and [-110] directions was an Ra of 3 nm, and no atomic steps were found.

### <Reference Example 7>

An n-channel lateral MOSFET was fabricated according to the present invention. First, a p-type homoepitaxial layer was grown by CVD on the (001) face of an n-type single-crystal cubic silicon carbide substrate with a carrier concentration of 3.0 x 10¹⁸/cm³. The growing conditions were in accordance with Table 6. The thickness of the film grown was adjusted by controlling the growth duration.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a hydrogen atmosphere at atmospheric pressure by the same method and under the same conditions as in Embodiment 1, but the surface remained smooth and no steps oriented in a specific direction suggesting the presence of a polar face were found.

Subsequently, N ion implantation and an annealing were conducted under the same conditions as in Embodiment 7. The activation rate of the N ion implantation regions was 80 percent.

Next, a gate insulating film 60 nm in thickness was formed in a dry oxygen atmosphere. In this process, the silicon carbide was oxidized thermally under the conditions in Table 7.

By photolithographic and etching steps, contact holes were provided in the gate insulating film as source and drain regions and source and drain electrodes and a gate electrode were formed. A TiN electrode 100 nm in thickness with a gate length of 2 micrometers and a gate width of 10 micrometers was employed as the gate electrode. Al 100 nm in thickness was employed as the source and drain electrodes.

Measurement of the drain current-drain voltage characteristics of the diode formed as set forth above using the gate voltage as a parameter revealed a specific on-resistance of 32.9 mΩ(OHM)·cm² and a maximum channel mobility of 25.5 cm²/V/s. The facts that the gate threshold voltage was +1.2 V and the transistor was normally off were confirmed. Next, the measurement temperature was changed from 300 K to 500 K to measure the temperature dependency of channel mobility. The channel mobility exhibited a proportional tendency of T^{-1.28} for temperature T, indicating a negative temperature coefficient.

Finally, the electrodes and the gate insulating film were removed with a 50 percent hydrofluoric acid. The center line average roughness of the silicon carbide surface at just under the gate was measured. The roughness along the [110] and [-110] directions was an Ra of 2 to 3 nm, and no atomic steps were found.

### <Reference Example 8>

An n-channel lateral MOSFET was fabricated according to the present invention. First, a p-type homoepitaxial layer was grown by CVD on the (001) face of an n-type single-crystal cubic silicon carbide substrate with a carrier concentration of 3.0 x 10¹⁸/cm³. The growing conditions were in accordance with Table 6. The thickness of the film grown was adjusted by controlling the growth duration.

Next, diamond slurry 1 micrometer in diameter were used to form abundant polishing grooves that were approximately parallel to the [-110] direction on the surface of the homoepitaxially grown cubic silicon carbide thin film. This step covered the surface of the cubic silicon carbide thin film with protrusions with the (111) and (-1-11) faces as missoriented directions. However, following the polishing stage, there were disordered surfaces the in addition to the ideal faces. The peak-valley height of the protrusions was about 2 nm, and the average distance between protrusion peaks was 1 micrometer.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Random steps were observed on this surface, and no steps of a polarity oriented in a specific direction were observed.

Subsequently, N ion implantation and an annealing were conducted under the same conditions as in Embodiment 7. The activation rate of the N ion implantation regions was 80 percent.

Next, a gate insulating film 60 nm in thickness was formed in a dry oxygen atmosphere. In this process, the silicon carbide was oxidized thermally under the conditions in Table 7.

By photolithographic and etching steps, contact holes were provided in the gate insulating film as source and drain regions and source and drain electrodes and a gate electrode were formed. A TiN electrode 100 nm in thickness with a gate length of 2 micrometers and a gate width of 10 micrometers was employed as the gate electrode. Al 100 nm in thickness was employed as the source and drain electrodes.

Measurement of the drain current-drain voltage characteristics of the diode formed as set forth above using the gate voltage as a parameter revealed a specific on-resistance of 74.7 mΩ(OHM)·cm² and a maximum channel mobility of 11.2 cm²/V/s. The facts that the gate threshold voltage was +1.2 V and the transistor was normally off were confirmed. Next, the measurement temperature was changed from 300 K to 500 K to measure the temperature dependency of channel mobility. The channel mobility exhibited a proportional tendency of T^{-1.57} for temperature T, indicating a negative temperature coefficient.

Finally, the electrodes and the gate insulating film were removed with a 50 percent hydrofluoric acid. The center line average roughness of the silicon carbide surface at just under the gate was measured. The roughness along the [110] and [-110] directions was an Ra of 2 to 3 nm, and no atomic steps were found.

### <Reference Example 9>

An n-channel lateral MOSFET was fabricated according to the present invention. First, a p-type homoepitaxial layer was grown by CVD on the (001) face of an n-type single-crystal cubic silicon carbide substrate with a carrier concentration of 3.0 x 10¹⁸/cm³. The growing conditions were in accordance with Table 6. The thickness of the film grown was adjusted by controlling the growth duration.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was annealed in a 100 percent hydrogen atmosphere at atmospheric pressure for 10 minutes, but the surface remained smooth and no steps oriented in a specific direction suggesting the presence of a polar face were found.

Subsequently, a photolithography step was used to ion implant N in prescribed source and drain regions. The ion implantations were conducted at an implantation temperature of 500°C in three stages of 200 keV, 120 keV, and 70 keV with a total dose of 7 x 10¹³/cm² to form source and drain regions consist of n-type regions that were 0.5 micrometer in depth and had a concentration of 1 x 10¹⁸/cm³ in the p-type region. Next, an annealing was conducted at 1,650°C for 10 minutes at atmospheric pressure in an Ar atmosphere to activate the N ion-implanted regions. The activation rate was 80 percent.

Next, a gate insulating film 60 nm in thickness was formed in a dry oxygen atmosphere. In this process, the silicon carbide was oxidized thermally under the conditions in Table 7. Once the gate insulating film had been formed, an annealing was conducted at 1,150°C in an N₂O atmosphere. This annealing caused the N atoms to diffuse into the gate oxide film, with N lodging at the gate insulating film/3C-SiC interface. The concentration of N lodging at the interface was determined by SIMS to be 2 x 10¹⁴/cm³.

By photolithographic and etching steps, contact holes were provided in the gate insulating film as source and drain regions and source and drain electrodes and a gate electrode were formed. A TiN electrode 100 nm in thickness with a gate length of 2 micrometers and a gate width of 10 micrometers was employed as the gate electrode. Al 100 nm in thickness was employed as the source and drain electrodes.

Measurement of the drain current-drain voltage characteristics of the diode formed as set forth above using the gate voltage as a parameter revealed a specific on-resistance of 3.0 mΩ(OHM)·cm² and a maximum channel mobility of 234 cm²/V/s. However, the gate threshold voltage became -2.1 V and normally on characteristics were exhibited. Next, the measurement temperature was changed from 300 K to 500 K to measure the temperature dependency of channel mobility. The channel mobility exhibited a proportional tendency of T^{+1.33} for temperature T, indicating a positive temperature coefficient.

Finally, the electrodes and the gate insulating film were removed with a 50 percent hydrofluoric acid. The center line average roughness of the silicon carbide surface at just under the gate was measured. The roughness along the [110] and [-110] directions was an Ra of 2 to 3 nm, and no atomic steps were found. The results obtained from Embodiments 6 to 9 and Reference Examples 6 to 9 have been collected into the following table.

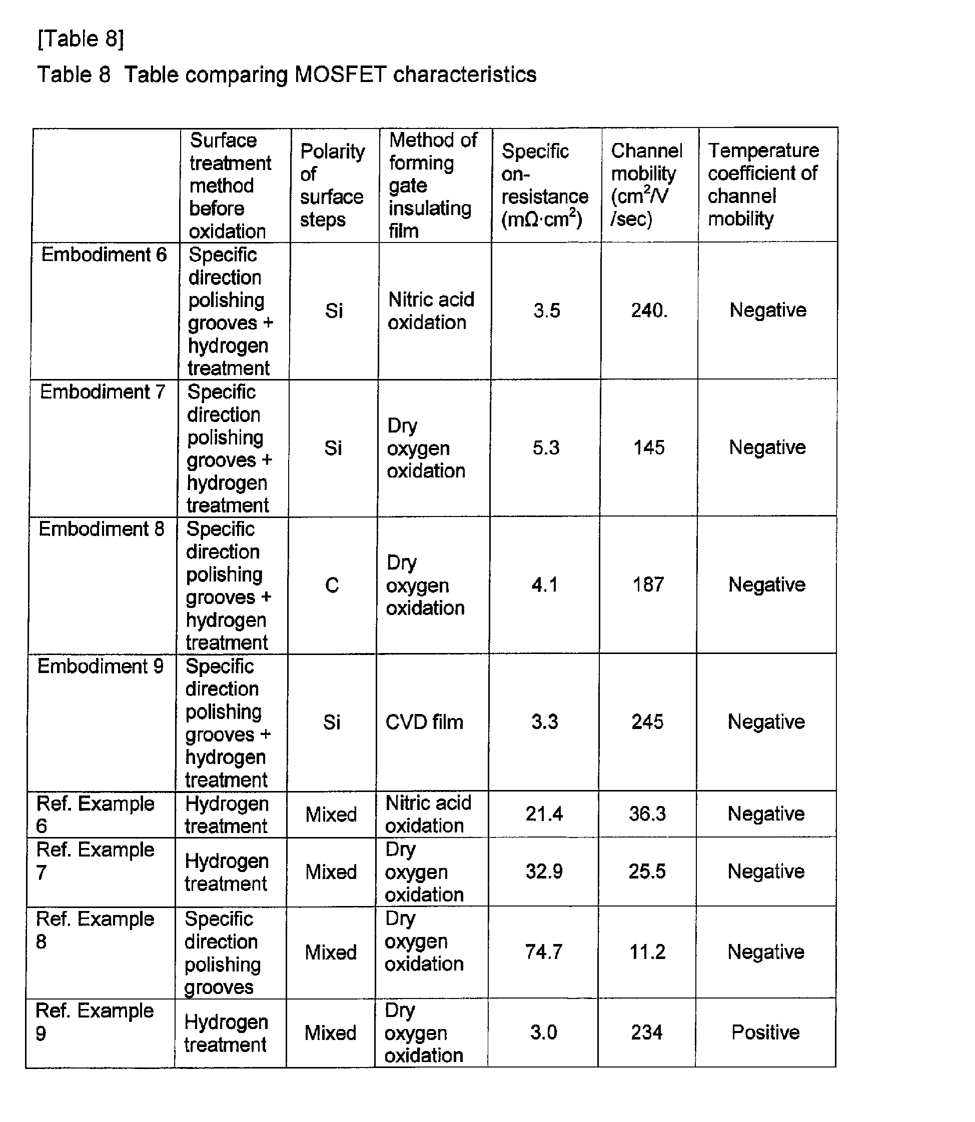

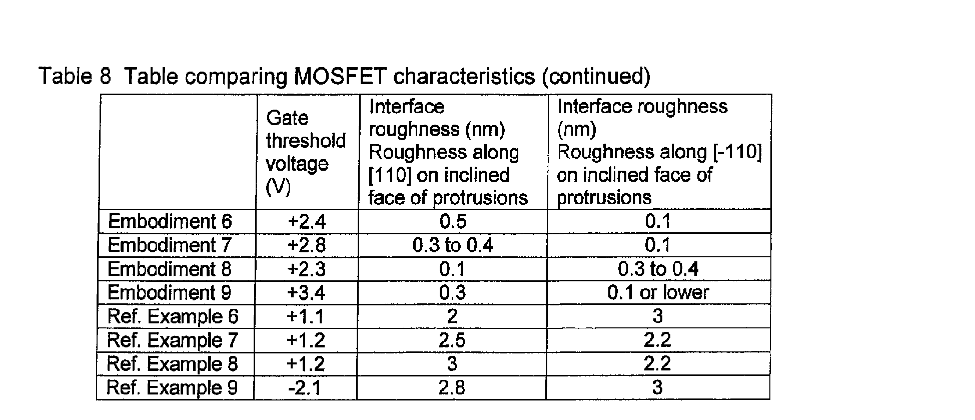

Table 8 reveals the following. A comparison of Embodiments 6 to 9 and Reference Examples 6 to 8 reveals that imparting a specific polarity to the steps at the atomic level on the 3C-SiC surface prior to forming the gate insulating film enhanced the smoothness of the MOS interface and achieved high channel mobility (a low specific on-resistance). The effect of imparting a specific polarity to the steps was achieved irrespective of the method used to form the gate insulating film.

Additionally, in Reference Example 9, subjecting the gate insulating film to a nitriding treatment as described in Japanese Unexamined Patent Publication (KOKAI) No. 2000-156478 enhanced channel mobility (lowered the specific on-resistance), but caused the gate threshold voltage to fluctuate in a negative direction and resulted in the channel mobility exhibiting a positive coefficient on temperature. The fact that the gate threshold voltage was negative meant that so long as a positive voltage was not applied to the gate electrode, the MOSFET was in an on state, resulting in undesirable operation for a power semiconductor device. As the temperature increased, the current flowing to the MOSFET increased, inducing a further increase in temperature. Thus, the MOSFET fabricated in Reference Example 9 would clearly result in out of control thermally. By contrast, imparting a specific polarity to the steps at the atomic level on the 3C-SiC surface in Embodiment 7 and 8 of the present invention not only achieved channel mobility equivalent to that of Reference Example 9 without subjecting the MOS interface to nitriding, but also resulted in channel mobility exhibiting negative temperature coefficient and a positive gate threshold voltage.

Based on the above, the present invention clearly provides a method for manufacturing MOSFETs that are of higher performance and more stable than those of prior art.

### <Embodiment 10>

A MOS oxide was fabricated according to the present invention. First, an n-type single-crystal cubic silicon carbide (110) substrate with a carrier concentration of 5.0 x 10¹⁶/cm³ was subjected to a four-degree missoriented polishing in the [110] direction. In the missoriented polishing, the substrate was attached to a wedge-shaped polishing base with a four-degree angle so that the [110] direction was oriented along the tilted surface.
Next, a missoriented polished surface was formed under the following conditions.

[Table 9]

**Table 9 Missoriented polishing conditions for SiC surface**

| | Polishing agent | Pressure (kg/cm²) | Processing time (min) |
|---|---|---|---|
| First polishing | 10 micrometers diamond slurry | 2.2 | 40 |
| Second polishing | 3 micrometers diamond slurry | 2.2 | 15 |
| Third polishing | 0.5 micrometer diamond slurry | 1.7 | 20 |
| Fourth polishing | Colloidal silica | 2.5 | 60 |

Next, to remove the crystal defect layer produced on the silicon carbide surface by the polishing groove generating step, thermal oxidation was conducted in a dry oxygen atmosphere at 1,100°C for 60 minutes, after which the thermal oxide film was removed by etching in 5 percent HF for 10 minutes. This process uniformly removed a 15 nm region of the silicon carbide surface while leaving the protrusion pattern intact.

Next, the substrate surface was washed under the conditions indicated in Table 3, immersed in dilute hydrofluoric acid solution for about 5 minutes, and rinsed (cleaned) with deionized water for 5 minutes to completely remove the native oxide film.

Next, an n-type homoepitaxial layer with a carrier concentration of 3.0 x 10¹⁵/cm³ was grown by CVD on the missoriented face that had been cleaned. The growing conditions were in accordance with Table 2. The thickness of the film grown was adjusted by controlling the growth duration.

Periodic steps that were oriented in the [110] direction appeared on the surface of the homoepitaxially grown layer that had been grown on the missoriented surface. The step height was 0.5 to 0.6 nm, corresponding to the height of two Si-C mono-layers. All of the step edge faces were of unified Si polarity. Subsequently, thermal oxidation was conducted in a dry oxygen atmosphere at 1,000°C for 600 minutes to form a thermal oxide film 45 to 55 nm in thickness on the surface of the cubic silicon carbide.

### <Embodiment 11>

A MOS oxide was fabricated according to the present invention. First, an n-type single-crystal hexagonal silicon carbide (4H-SiC) (01-10) substrate with a carrier concentration of 5.0 x 10¹⁶/cm³ was subjected to a four-degree missoriented polishing in the [0001] direction. In the missoriented polishing, the substrate was attached to a wedge-shaped polishing base with a four-degree angle so that the [0001] direction was oriented along the tilted surface.
Next, a missoriented polished surface was formed under the conditions shown in Table 9.

Next, to remove the crystal defect layer produced on the silicon carbide surface by the polishing groove generating step, thermal oxidation was conducted in a dry oxygen atmosphere at 1,100°C for 60 minutes, after which the thermal oxide film was removed by etching in 5 percent HF for 10 minutes. This process uniformly removed a 15 nm region of the silicon carbide surface while leaving the protrusion pattern intact.

Next, the substrate surface was washed under the conditions indicated in Table 3, immersed in dilute hydrofluoric acid solution for about 5 minutes, and rinsed (cleaned) with deionized water for 5 minutes to completely remove the native oxide film.
Next, an n-type homoepitaxial layer with a carrier concentration of 3.0 x 10¹⁵/cm³ was grown by CVD on the missoriented face that had been cleaned. The growing conditions were in accordance with Table 10. The thickness of the film grown was adjusted by controlling the growth duration.

[Table 10]

**Table 10 Homoepitaxial growing conditions on hexagonal silicon carbide**

| | |
|---|---|
| Growth temperature (°C) | 1,750 |
| SiH₄ flow rate (sccm) | 30 |
| C₃H₈ flow rate (sccm) | 21 |
| NH₃ flow rate (sccm) | 0.5 |
| H₂ flow rate (slm) | 4 |
| Pressure (Torr) | 20 |
| Thickness of film grown (micrometers) | 15 |

Periodic steps that were oriented in the [0001] direction appeared on the surface of the homoepitaxially grown layer on the missoriented surface. The step height was 0.5 to 0.6 nm, corresponding to the height of two Si-C mono-layers. All of the step edge faces were of unified Si polarity. Subsequently, thermal oxidation was conducted in a dry oxygen atmosphere at 1,200°C for 600 minutes to form a thermal oxide film 45 to 55 nm in thickness on the surface of the hexagonal silicon carbide.

### <Reference Example 10>

A MOS diode was fabricated as set forth below as a reference example. First, an n-type homoepitaxial layer with a carrier concentration of 3.0 x 10¹⁵/cm³ was grown by CVD on the surface of an n-type single-crystal cubic silicon carbide (011) substrate with a carrier concentration of 5.0 x 10¹⁶/cm³*.* The growing conditions were in accordance with Table 2. The thickness of the film grown was adjusted by controlling the growth duration.

The surface of the epitaxially grown layer was smooth and no steps 59.13oriented in a specific direction were observed.

Subsequently, thermal oxidation was conducted in a dry oxygen atmosphere at 1,000°C for 600 minutes to form a thermal oxide film 45 to 55 nm in thickness on the surface of the cubic silicon carbide.

### <Reference Example 11>

A MOS diode was fabricated as set forth below as a reference example. First, an n-type homoepitaxial layer with a carrier concentration of 3.0 x 10¹⁵/cm³ was grown by CVD on the surface of an n-type single-crystal hexagonal silicon carbide (4H-SiC) (01-10) substrate with a carrier concentration of 5.0 x 10¹⁶/cm³. The growing conditions were in accordance with Table 10. The thickness of the film grown was adjusted by controlling the growth duration.

The surface of the homoepitaxially grown layer grown on the missoriented surface was smooth and no steps oriented in a specific direction were observed.

Subsequently, thermal oxidation was conducted in a dry oxygen atmosphere at 1,200°C for 600 minutes to form a thermal oxide film 45 to 55 nm in thickness on the surface of the hexagonal silicon carbide.

Nickel was deposited to a thickness of 100 nm by the same method and under the same conditions as in Embodiment 1 on the surface of the homoepitaxial cubic silicon carbide film on which a thermal oxide film had been formed, and nickel was evaporated to a thickness of 100 nm over the entire back surface of the n-type single-crystal cubic silicon carbide substrate to fabricate MOS diode arrays on the silicon carbide substrates in a 20 mm square pattern on the four samples of Embodiments 10 and 11 and Reference Examples 10 and 11.

Next, the oxide film thickness was obtained from measurement of the oxide film capacitance and the breakdown voltage was obtained from current - voltage measurements for the MOS diode arrays. The oxide film dielectric breakdown field strength and standard deviation thereof were then calculated from the oxide film thickness and breakdown voltage.

The oxide film was then removed with a 50 percent hydrofluoric acid and the centerline average roughness of the exposed silicon carbide surface was measured for Embodiments 10 and 11 and Reference Examples 10 and 11 for which measurement of the breakdown voltage of the MOS diode had been completed. Measurement results of the oxide film dielectric breakdown field strength and centerline roughness on the surface from which the oxide film had been removed have been organized into Table 11 for each sample. With the samples in which the polarity of the steps at the atomic level on the surface was unified based on the present invention prior to oxide film formation, the oxide films that were formed exhibited good dielectric breakdown field strength and high wafer in-plane uniformity. From the results of measurement of the surface roughness of the surface from which the oxide film had been removed following measurement of the breakdown voltage, it was determined that the samples of the embodiments of the present invention yielded smooth oxide film/silicon carbide interfaces. These results, which were similar to those of Embodiment 5, indicated that the effects of polar dependency on the thermal oxidation rate were reduced by microscopically unifying the step polarity on the surface of a macroscopically nonpolar face. These results in combination with the knowledge obtained from Embodiments 5 to 9 indicate that the present invention provides a means of obtaining good device characteristics, not just for nonpolar faces of 3C-SiC, but also for hexagonal SiC.

[Table 11]

**Table 11 A comparison of the effect of the present invention for the (011) face of cubic silicon carbide and the (01-10) face of hexagonal silicon carbide**

| | Type of silicon carbide | Face direction | Dielectric breakdown field strength of oxide film, standard deviation (MV/cm) | Average centerline roughness (nm) of surface from which oxide film removed; parallel to steps | Average centerline roughness (nm) of surface from which oxide film removed; orthogonal to steps |
|---|---|---|---|---|---|
| Embodiment 10 | Cubic | (011) | 8.0 ± 0.1 | 0.2 | 0.8 |
| Reference Example 10 | Cubic | (011) | 7.4 ± 0.5 | 2.2 | 2 |
| Embodiment 11 | Hexagonal (4H) | (01-10) | 8.2 ± 0.2 | 0.1 | 0.6 |
| Reference Example 11 | Hexagonal (4H) | (01-10) | 7.3 ± 0.4 | 2 | 2.4 |

Embodiments relating to the formation of Schottky diodes, MOS diodes, and MOSFETs on cubic silicon carbide (001) and (011) faces and on the hexagonal silicon carbide (01-10) face have been set forth above. However, the effects of the present invention are not limited to the semiconductor devices fabricated on a trial basis in the embodiments. These effects are achieved in all semiconductor devices having a metal/silicon carbide structure or a metal/insulating film/silicon carbide structure. Nor are they limited by the method of unifying the surface polarity or the means of forming the insulating film; so long as the polarity of the surface is nonpolar, the same effect is achieved in any face direction.

### <Embodiment 12>

A p-type homoepitaxial layer was grown by CVD on the (001) face of an n-type single-crystal cubic silicon carbide substrate having a carrier concentration of 3.0 x 10¹⁸/cm³. The growing conditions were in accordance with Table 6. The thickness of the film grown was adjusted by controlling the growth duration.

Diamond slurry 0.1 micrometer in diameter were used to form abundant polishing grooves that were approximately parallel to the [-110] direction on the surface of a cubic silicon carbide thin film that had been homoepitaxially grown. This step covered the surface of the cubic silicon carbide thin film with protrusions with the (111) and (-1-11) faces as missoriented directions. The peak-valley height of the protrusions was about 6 nm, and the average distance between protrusions, at 5 nm, was extremely fine structure.

Next, thermal oxidation, etching, immersion in dilute hydrofluoric acid solution, and rinsing (cleaning) were sequentially conducted by the same methods and under the same conditions as in Embodiment 1 to completely remove the native oxide film.

Subsequently, the cubic silicon carbide substrate was exposed in molten KOH at a temperature of 500°C for 20 minutes and the silicon carbide surface was anisotropically etched. As a result, the surface of the cubic silicon carbide substrate was covered with repeating sawtooth-like protrusions having an inclined surfaces with angles of inclination of 54.7° and 125.3° against the (001) face, that is, in which the (111) and (-1-11) Si faces were continuous. The height of the protrusions was about 3 nm.

Subsequently, N ion implantation and annealing were conducted under the same conditions as in Embodiment 7. The activation rate was 80 percent in the N ion implantation region.

Next, a gate insulating film was formed in a dry oxygen atmosphere. The thermal oxidation of the silicon carbide was conducted under the conditions in Table 7. A quartz reaction tube was employed in thermal oxidation. At atmospheric pressure, 3 slm of oxygen was fed and processing was conducted at 1,100°C for 60 min. The fact that an oxide film 60 nm in thickness had been formed on the surface of the silicon carbide was determined following processing by SIMS depth profile analysis.

By photolithographic and etching steps, contact holes were provided in the gate insulating film as source and drain regions and source and drain electrodes and a gate electrode were formed. A TiN electrode 100 nm in thickness with a gate length of 2 micrometers and a gate width of 10 micrometers was employed as the gate electrode. Al 100 nm in thickness was employed as the source and drain electrodes.

Measurement of the drain current-drain voltage characteristics of the MOSFET formed as set forth above using the gate voltage as a parameter revealed a specific on-resistance of 5.3 mΩ(OHM)·cm² and a maximum channel mobility of 250 cm²/V/s. The facts that the gate threshold voltage was +2.8 V and the transistor was normally off were confirmed. Next, the measurement temperature was changed from 300 K to 500 K to measure the temperature dependency of channel mobility. The channel mobility exhibited a proportional tendency of T^{-1.82} for temperature T, indicating a negative temperature coefficient.

Finally, the electrodes and the gate insulating film were removed with a 50 percent hydrofluoric acid. The center line average roughness of the silicon carbide surface at just under the gate was measured. The roughness along the [110] direction, which intersected the sawtooth shape, was an Ra of 3 to 4 nm, and the roughness along the [-110] direction, lying within the inclined surface of the protrusions, was an Ra of about 0.1 nm. The roughness along the [-110] direction, in which no atomic steps appeared, was about Ra 0.1 nm.

### <Embodiment 13>

The temperature dependency of hydrogen treatment of the SiC surface was examined. First, a p-type homoepitaxial layer was grown by CVD on the (001) face of an n-type single-crystal cubic silicon carbide substrate having a carrier concentration of 3.0 x 10¹⁸/cm³. The growing conditions were in accordance with Table 6. Further, diamond slurry 1 micrometer in diameter were employed to form abundant polishing grooves approximately parallel to the [-110] direction of the surface of the cubic silicon carbide substrate that had been epitaxially grown. Next, to remove the crystal defect layer produced on the surface of the silicon carbide by the polishing groove generating step, thermal oxidation was conducted in a dry oxygen atmosphere at 1,100°C for 60 minutes, after which the thermal oxide film was removed by etched in 5 percent HF for 10 minutes. This step uniformly removed a 15 nm region of the silicon carbide surface while leaving the protrusion pattern intact.

Next, after RCA cleaning, the single-crystal silicon carbide substrate was immersed in a dilute hydrofluoric acid solution for about 5 minutes and rinsed (cleaned) with deionized water for 5 minutes to completely remove the native oxide film.
The single-crystal silicon carbide substrate was subjected to hydrogen treatment at temperatures of from 200°C to 800°C.

At 200°C, the silicon carbide surface was hardly etched. The silicon carbide surface was observed by AFM, but no atomic steps were found. In the temperature range from 300 to 600°C, a steplike surface with Si polar faces about 0.5 nm in height was observed on the silicon carbide surface following hydrogen treatment. At temperatures of 700°C and above, steps orienting two directions were observed suggesting generation of mixed porality. The step height, at 2 nm and above, was substantial.

Subsequently, all of the samples were subjected to N ion implantation and annealing under the same conditions as in Embodiment 7. The activation rate in the N ion implanted region was 80 percent.

Next, the silicon carbide substrate was subjected to nitric acid oxidation. That is, it was heated to boiling after being immersed in a 60 weight percent concentration nitric acid aqueous solution at room temperature. The state of boiling was continued to achieve an azeotropic state with a boiling point of 120.7°C and a nitric acid concentration of 68 percent (weight ratio). This azeotropic state was subsequently continued for several hours to form a gate insulating film having a thickness of 30 nm. By photolithographic and etching steps, contact holes were provided in the gate insulating film as source and drain regions and source and drain electrodes and a gate electrode were formed. A TiN electrode 100 nm in thickness with a gate length of 2 micrometers and a gate width of 10 micrometers was employed as the gate electrode. Al 100 nm in thickness was employed as the source and drain electrodes.

The drain current-drain voltage characteristics of the MOSFET fabricated as set forth above were measured using the gate voltage as a parameter. The specific on-resistance and channel mobility have been summarized in Table X. Finally, the electrodes and the gate insulating film were removed with a 50 percent hydrofluoric acid. The center line average roughness of the silicon carbide surface at just under the gate was measured. The results of the measurement of the centerline average roughness of the silicon carbide surface immediately beneath the gate are given in Table 12.

[Table 12]

**Table 12 Dependency on temperature of hydrogen treatment**

| Hydrogen treatment temperature (°C) | Polarity of interface steps | Specific on-resistance (mΩ(OHM)·cm²) | Channel mobility (cm²/V/s) | Interface roughness Ra (nm) |
|---|---|---|---|---|
| 200 | None | 50.5 | 35 | 0.2 |
| 300 | Si | 5.3 | 185 | 0.2 |
| 400 | Si | 3.3 | 245 | 0.1 |
| 500 | Si | 4.0 | 225 | 0.1 |
| 600 | Si | 5.2 | 240 | 0.2 |
| 700 | Mixed | 21 | 170 | 0.8 |
| 800 | Mixed | 32 | 145 | 1.2 |

MOSFET samples in which the silicon carbide surface prior to MOSFET fabrication was a silicon carbide substrate imparted with faces of a specific polarity, that is, that had been fabricated with silicon carbide substrates at a hydrogen treatment temperature falling within a range of 300 to 600°C, exhibited desirable values in the form of a specific on-resistance of 3 to 5.3 mΩ(OHM)·cm² and a channel mobility of 185 to 245 cm²/V/s. The roughness of the MOS interface was Ra = 0.2 nm or lower.

MOSFETs fabricated with samples obtained on surface with mixed polarity consist of Si faces and C faces on the substrate surface, that is, using silicon carbide substrates that had been treated with hydrogen at temperatures of 700°Cand 800°C, exhibited characteristics in the form of high specific on-resistances of 20 mΩ(OHM)·cm² or greater and channel mobilities of 145 to 170 cm²/V/s. The roughness of the MOS interface, at Ra = 0.8 to 1.2 nm, was higher than for other samples.
MOSFETs fabricated with samples the silicon carbide surfaces of which were not etched during hydrogen treatment, that is, using silicon carbide substrates that were treated with hydrogen at a temperature of 200°C, exhibited characteristics in the form of high specific on-resistances and a low channel mobility of 50 cm²/V/s.

On this basis, MOSFETs that were fabricated using single-crystal cubic silicon carbide substrates that had been surface treated with hydrogen at 300 to 600°C had smooth MOS interfaces. As a result, they exhibited superior carrier transfer performances in channel region, and had thermal stability that was little affected by Coulomb scattering and interface states during high-temperature operation.

### Brief Description of the Drawings

[Fig. 1] A structural diagram of a Schottky barrier diode.
[Fig. 2] A structural diagram of a lateral MOSFET.
[Fig. 3] An image showing polishing grooves (protrusions) approximately parallel to the [-110] direction provided on a substrate surface.
[Fig. 4] The upper portion is an image of a steplike surface having step edges aligned in the [-110] direction, and the lower portion is an atomic model of a step edge face with a cross-section of the (-110) face.
[Fig. 5] A descriptive drawing of the crystal structure of hexagonal silicon carbide.
[Fig. 6] Shows the pattern of periodic steps having step edge faces parallel to the [-110] direction obtained in Embodiment 1. The upper portion is an AFM image of the (001) face of 3C-SiC. The lower portion is a cross-section of the (-110) face of 3C-SiC.
[Fig. 7] Shows the result of obtaining the oxide film thickness from measurements of the oxide film capacitance and that of measuring the breakdown voltage based on current-voltage measurement for the MOS diode arrays fabricated in Embodiment 5 and Reference Example 5 (Lower portion). The upper portion is a profile of the cross-section of the (110) face of 3C-SiC.

### [Key to the Numbers]

- 11:: Silicon carbide substrate
- 12:: Silicon carbide epitaxial layer
- 13:: Schottky electrode
- 14:: Backside electrode of substrate
- 21:: Silicon carbide substrate
- 22:: Silicon carbide epitaxial layer
- 23:: Source region
- 24:: Drain region
- 25:: Source electrode
- 26:: Drain electrode
- 27:: Gate insulating film
- 28:: Gate electrode

## Claims

1. A semiconductor device, comprising a semiconductor substrate comprised of silicon carbide, a gate insulating film formed on the semiconductor substrate, and a gate electrode formed on the gate insulating film, **characterized in that**:
the junction surface of the semiconductor surface and the gate insulating film is macroscopically parallel to a nonpolar face, is microscopically comprised of the nonpolar face and a polar face, with either an Si face or a C face being dominant in the polar face.

2. A semiconductor device, comprising a semiconductor substrate comprised of silicon carbide, a gate insulating film formed on the semiconductor substrate, and a gate electrode formed on the gate insulating film, **characterized in that:**
the junction surface of the semiconductor surface and the gate insulating film comprises a terrace face, and a step edge oriented in a specific direction,
the terrace face corresponds to a nonpolar face, and the step edge is comprised of a polar face of either an Si face or a C face.

3. A semiconductor device, comprising a semiconductor substrate comprised of silicon carbide, a gate insulating film formed on the semiconductor substrate, and a gate electrode formed on the gate insulating film, **characterized in that:**
the junction surface of the semiconductor surface and the gate insulating film comprises a terrace face, and a step edge oriented in a specific direction,
the terrace face corresponds to a nonpolar face, and
the terrace face has a ratio of the width in the direction of orientation of the step edge to the width in the in-plane direction orthogonal to the direction of orientation of the step edge of ten-fold or greater.

4. A semiconductor device, comprising a semiconductor substrate comprised of silicon carbide, a gate insulating film formed on the semiconductor substrate, and a gate electrode formed on the gate insulating film, **characterized in that:**
the junction surface of the semiconductor surface and the gate insulating film is macroscopically parallel to a nonpolar face, comprises a step edge oriented in a specific direction, and the height of the step edge falls within a range of 0.5 to 10 nm.

5. A semiconductor device, comprising a semiconductor substrate comprised of silicon carbide and an electrode formed on the semiconductor substrate, **characterized in that:**
the junction surface of the semiconductor substrate surface and the electrode is macroscopically parallel to a nonpolar face and is microscopically comprised of the nonpolar face and a polar face, with either an Si face or a C face being dominant in the polar face.

6. A semiconductor device, comprising a semiconductor substrate comprised of silicon carbide and an electrode formed on the semiconductor substrate, **characterized in that:**
the junction surface of the semiconductor substrate surface and the electrode comprises a terrace face, and a step edge oriented in a specific direction;
the terrace face corresponds to a nonpolar face; and
the step edge face is comprised of a nonpolar face and a polar face in the form of either an Si face or a C face.

7. A semiconductor device, comprising a semiconductor substrate comprised of silicon carbide and an electrode formed on the semiconductor substrate, **characterized in that:**
the junction surface of the semiconductor substrate surface and the electrode comprises a terrace face, and a step edge oriented in a specific direction,
the terrace face corresponds to a nonpolar face, and
terrace face has a ratio of the width in the in-plane direction orthogonal to the step direction to the width in the step direction of ten-fold or greater.

8. A semiconductor device, comprising a semiconductor substrate comprised of silicon carbide and an electrode formed on the semiconductor substrate, **characterized in that:**
the junction surface of the semiconductor substrate surface and the electrode is macroscopically parallel to a nonpolar face and contains recessions and protrusions oriented in a specific direction; and
the height between the recessions and protrusions falls within a range of 0.5 to 10 nm.

9. The semiconductor device according to any one of claims 1, 2, 5, and 6, **characterized in that** the proportion of the area occupied by one of the polar faces in the junction surface falls within a range of 0.75 to 1 when the area of all of the polar faces in the junction surface is denoted as 1.

10. The semiconductor device according to any one of claims 2, 3, 6, and 7, **characterized in that** the width of the terrace face (the width in the substrate in-plane direction orthogonal to the direction of orientation of the step edge) is 0 to 100 nm.

11. The semiconductor device according to any one of claims 1 to 10, **characterized in that** the semiconductor substrate comprises a silicon carbide epitaxial film formed on a single-crystal semiconductor substrate.

12. The semiconductor device of any one of claims 1 to 11, **characterized in that** the semiconductor substrate is cubic silicon carbide and the nonpolar face is the {001} or {110} planes.

13. The semiconductor device according to any one of claims 1 to 11, **characterized in that** the semiconductor substrate is hexagonal silicon carbide and the nonpolar plane corresponds to any one of the {11-20}, {1-100}, and {03-38} planes.

14. The semiconductor substrate of any one of claims 1, 2, 5, 6, and 9, **characterized in that** the specified polar face is the Si polar face.

15. A method for manufacturing the semiconductor device according to any one of claims 1 to 14, **characterized by** comprising the steps of:
preparing a silicon carbide semiconductor substrate having at least one dominant surface that is a nonpolar face;
forming steps oriented in a specific direction on at least a portion of a nonpolar face of the semiconductor substrate; and
unifying the polarity of the step edge face to a specific polar face.

16. The manufacturing method according to claim 15, **characterized in that** the step of forming steps in a specific direction and the step of unifying the polarity of the step edge face to a specific polar face are conducted before a step of forming a gate insulating film or electrode.
